# EUROPÄISCHE PATENTSCHRIFT

(11) **EP 3 845 727 B1**
(45) Veröffentlichungstag und Bekanntmachung des Hinweises auf die Patenterteilung: **16.11.2022**
(21) Anmeldenummer: 20215463.9
(22) Anmeldetag: 18.12.2020
(51) Int. Cl.: E05B 17/00, E05B 79/06, E05B 81/76, E05B 85/16, E05B 85/10

(54) **TÜRGRIFF FÜR EIN FAHRZEUG**
DOOR HANDLE FOR A VEHICLE
POIGNÉE DE PORTE POUR UN VÉHICULE

(30) Priorität: 23.12.2019 DE 102019135774
(43) Veröffentlichungstag der Anmeldung: 07.07.2021
(73) Patentinhaber: Mercedes-Benz Group AG, 70372 Stuttgart (DE)
(72) Erfinder: Reifenberg, Bernd, 45259 Essen (DE)
(74) Vertreter: Hofstetter, Schurack & Partner

(56) Entgegenhaltungen:
- EP-A1- 1 306 503
- EP-A1- 3 578 740
- DE-A1- 10 232 583
- DE-A1-102016 116 885

## Beschreibung

Die vorliegende Erfindung betrifft einen Türgriff für ein Fahrzeug, insbesondere ein Kraftfahrzeug. Ferner betrifft die Erfindung eine Griffanordnung für ein Fahrzeug. Zudem betrifft die Erfindung auf ein Verfahren zur Herstellung einer Griffanordnung.

Aus dem Stand der Technik sind Türgriffe für Fahrzeuge bekannt, welche meist innerhalb einer Kavität des Türgriffs zusätzliche elektronische Bauteile aufweisen. Die elektronischen Bauteile dienen dabei beispielsweise zur Detektion einer Betätigung des Türgriffs, beispielsweise einer Annäherung und/oder einer Berührung. In Abhängigkeit von der Detektion der Betätigung erfolgt üblicherweise eine Ansteuerung eines Sicherheitssystems, insbesondere eines Schließsystems, des Fahrzeuges. Um diese Funktionalität bereitstellen zu können, müssen die elektronischen Bauteile im Türgriff mit einer Elektronik des Fahrzeuges außerhalb des Türgriffes verbunden werden.

Hierzu wird üblicherweise bei einer Montage des Türgriffs das elektronische Bauteil, beispielsweise eine Platine mit elektronischen Bauelementen, mit einem daran befestigten Kabel in die Kavität des Türgriffs eingebracht. Das Kabel wird anschließend aus der Kavität des Türgriffs durch eine Öffnung des Türgriffs herausgeführt um beispielsweise mittels einer Steckverbindung mit einer fahrzeugseitigen Elektronik elektronisch verbunden.

Dies hat allerdings den Nachteil, dass eine Herstellung des Türgriffes sehr aufwendig ist und kompliziert durchzuführen ist. Insbesondere das Herausführen des elektrischen Kabels aus der Kavität ist eine schwierige Aufgabe, welche nur manuell und mit hohem Zeitaufwand durchzuführen ist. Gleichzeitig steigen die Anforderungen an die Positionierung und/oder Befestigung der Platine beziehungsweise des mit der Platine verbundenen Kabels, um eine zuverlässige elektrische Verbindung und damit Funktionsfähigkeit des Türgriffs zu gewährleisten.

Aus der EP3578740 ist ein Türgriff mit einer elektronischen Einheit und einer elektrischen Steckereinheit bekannt, wobei die letztere ein elektrisch leitendes Steckerelement aufweist, das an einer Trägereinheit der elektronischen Einheit stoffschlüssig befestigt ist.

Es ist daher eine Aufgabe der vorliegenden Erfindung, die voranstehend beschriebenen Nachteile zumindest zum Teil zu überwinden, insbesondere einen verbesserten Türgriff für ein Fahrzeug bereitzustellen. Ferner ist es eine Aufgabe der vorliegenden Erfindung, einen kostengünstigen, einen einfachen im Zusammenbau und einem einfachen bei der Montage am Fahrzeug Türgriff zu ermöglichen. Zudem ist es eine Aufgabe der Erfindung, eine entsprechende, verbesserte Griffanordnung für ein Fahrzeug zur Verfügung zu stellen. Außerdem ist es eine Aufgabe der Erfindung, ein verbessertes Verfahren zur Herstellung einer Griffanordnung bereitzustellen, wobei die Herstellung der Griffanordnung den Zusammenbau des Türgriffes und die Montage des Türgriffes am Fahrzeug mithilfe einer Lagerkupplung umfasst, und wobei das Verfahren einfach, schnell und mit wenig Aufwand durchgeführt werden kann.

Die voranstehende Aufgabe wird gelöst durch einen Türgriff mit den Merkmalen des unabhängigen Vorrichtungsanspruches, eine Griffanordnung mit den Merkmalen des nebengeordneten Vorrichtungsanspruches sowie durch ein Verfahren mit den Merkmalen des Verfahrensanspruches. Weitere Merkmale und Details der Erfindung ergeben sich aus den jeweiligen Unteransprüchen, der Beschreibung und den Zeichnungen. Dabei gelten Merkmale und Details, die im Zusammenhang mit dem erfindungsgemäßen Türgriff und/oder mit der erfindungsgemäßen Griffanordnung beschrieben sind, selbstverständlich auch im Zusammenhang mit dem erfindungsgemäßen Verfahren, und jeweils umgekehrt, sodass bezüglich der Offenbarung zu den einzelnen Erfindungsaspekten stets wechselseitig Bezug genommen wird bzw. werden kann.

Die voranstehend beschriebene Aufgabe wird gelöst durch einen Türgriff für ein Fahrzeug, vorzugsweise ein Kraftfahrzeug, insbesondere ein Türaußengriff für ein bewegliches Teil des Fahrzeuges, aufweisend:
- eine Kavität, welche zumindest teilweise durch ein Gehäuse des Türgriffs gebildet ist, und
- eine elektronische Einheit, welche in der Kavität aufgenommen ist,
wobei die elektronische Einheit eine Trägereinheit, insbesondere eine elektrische Platine, wie z. B. Leiterplatte oder gedruckte Schaltung, aufweist,
- eine elektrische Steckereinheit, welche mindestens ein elektrisch leitendes Steckerelement, insbesondere umfassend mindestens einen Kontaktstift, aufweist,
wobei das mindestens eine Steckerelement an der Trägereinheit stoffschlüssig befestigt, insbesondere gelötet, geschweißt oder geklebt, ist,
wobei die elektrische Steckereinheit zum Befestigen einer Lagerkupplung, die mit einer elektrischen Leitung ausgeführt ist, an der elektrischen Steckereinheit ausgeführt ist, wodurch der Türgriff am Fahrzeug, insbesondere an einem Montageträger des Fahrzeuges, mechanisch, insbesondere lösbar, vorzugsweise form- und/oder kraftschlüssig, befestigt wird und zugleich die elektronische Einheit mit der elektrischen Leitung der Lagerkupplung elektrisch verbunden wird.

Der Türgriff kann vorzugsweise als ein flächenbündiger Türgriff ausgebildet sein, welcher zum Erreichen einer Betriebsstellung aus der Außenseite des beweglichen Teils herausfahrbar ist. In der Betriebsstellung dient der Türgriff zur Betätigung des beweglichen Teils. Zur Betätigung kann z. B. eine Kraftausübung, insbesondere ein Ziehen und/oder Drücken, am Türgriff erfolgen, sodass das bewegliche Teil entriegelbar und/oder bewegbar ist. Der Türgriff kann speziell für ein Keyless-Entry- und/oder Keyless-Go-Sicherheitssystem ausgebildet sein.

Die Trägereinheit im Sinne der Erfindung kann zur Aufnahme von elektronischen Bauelementen dienen, wie bspw. von elektrischen Widerständen und/oder Kondensatoren und/oder Spulen. Ebenfalls kann die Trägereinheit auch zumindest einen Mikroprozessor und/oder einen integrierten Schaltkreis und/oder eine oder mehrere Sensoreinheiten und/oder eine oder mehrere Leiterbahnen aufnehmen.

Erfindungsgemäß umfasst die Trägereinheit mindestens ein elektrisch leitendes Steckerelement in Form von mindestens einem Kontaktstift, welches bzw. welcher stoffschlüssig, insbesondere durch Löten, Schweißen oder Kleben, mit der Trägereinheit verbunden ist.

So kann das mindestens eine elektrisch leitende Steckerelement zusammen mit der elektrischen Steckereinheit einen männlichen Steckerteil bilden, welcher im Türgriff integriert ist. Somit ist es möglich den Türgriff ohne ein Kabel bereitzustellen. Nach dem Anordnen des Türgriffes von außen am Fahrzeug, insbesondere am beweglichen Teil des Fahrzeuges, kann von innen bzgl. des Fahrzeuges bzw. von innen bzgl. des beweglichen Teils des Fahrzeuges eine separate Steckerbuchse zum Steckerelement geführt werden, die an der elektrischen Steckereinheit mechanisch befestigt und zugleich mit dem mindestens einen elektrisch leitenden Steckerelement elektrisch angebunden werden kann. Die Steckerbuchse kann wiederum mit einem Kabel ausgeführt sein, welches zu einer Elektronik des Fahrzeuges führen kann und/oder welches zu einem weiteren Stecker führen kann. Somit kann die Montage des Türgriffes am Fahrzeug, insbesondere am beweglichen Teil des Fahrzeuges, sowie die Verschaltung der elektronischen Einheit mit der Elektronik des Fahrzeuges erheblich vereinfacht werden.

Außerdem ist es mit dem erfindungsgemäßen Türgriff nicht notwendig, dass die elektrische Steckereinheit von vornherein, bspw. beim Herstellen des Türgriffes, d. h. beim Einsetzen der elektronischen Einheit in die Kavität, mit einem Kabel gehanhabt werden muss. Die Montage und/oder Anordnung und/oder Positionierung der elektronischen Einheit, insbesondere der Trägereinheit, innerhalb der Kavität des Türgriffs wird damit deutlich vereinfacht. Vorteilhafterweise kann somit ein einfacher Zusammenbau des Türgriffes, auch voll automatisch über einen Roboter, ermöglicht werden.

Im Rahmen der Erfindung wird unter einer elektrischen Verbindung im Rahmen der Erfindung verstanden, dass eine elektrische Signalverbindung hergestellt ist und/oder eine elektrische Energieübertragung erfolgen kann. Beispielsweise liegt eine elektrische Verbindung zwischen zwei Elementen dann vor, wenn zwischen diesen beiden Elementen eine elektrische leitende Verbindung z. B. über eine Leiterbahn besteht. Entsprechend ist es für eine elektrische Verbindung nicht zwangsläufig notwendig, dass die miteinander elektrisch verbundenen Elemente auch physikalisch direkt miteinander verbunden sein müssen.

Ferner kann die Erfindung vorsehen, dass die elektrische Steckereinheit und/oder die elektronische Einheit kabellos ausgeführt sind/ist. Somit kann die Handhabung der elektrischen Steckereinheit und/oder der elektronischen Einheit bei der Montage und/oder Anordnung und/oder Positionierung innerhalb der Kavität des Türgriffes bzw. der Zusammenbau des Türgriffes erheblich erleichtert. Nach dem Zusammenbau des Türgriffes kann ein fertiger kabelloser Türgriff von außen zum beweglichen Teil des Fahrzeugs geführt werden, um an einer Lagerkupplung montiert zu werden, die von innen zum beweglichen Teil des Fahrzeugs geführt werden kann. Die Lagerkupplung kann wiederum eine elektrische Leitung, insbesondere ein Kabel, aufweisen, die mit der elektrischen Steckereinheit mechanisch, insbesondere lösbar, vorzugsweise form- und/oder kraftschlüssig, bevorzugt durch eine Rastverbindung, befestigbar werden kann, wodurch die elektronische Einheit mit der elektrischen Leitung, insbesondere dem Kabel, der Lagerkupplung elektrisch verbunden werden kann.

Weiterhin kann die Erfindung vorsehen, dass die Trägereinheit als eine elektrische Platine, insbesondere in Form einer Leiterplatte oder einer gedruckten Schaltung, ausgebildet ist. Somit kann eine elektronische Einheit mit vorteilhafter Funktionalität bereitgestellt werden.

Denkbar ist es im Rahmen der Erfindung zudem, dass die Trägereinheit mindestens eine Leiterbahn und/oder mindestens eine Sensoreinheit aufweist, welche über das mindestens eine Steckerelement mit einer Steckerbuchse elektrisch verbindbar sind/ist. Somit kann eine Betätigung des Türgriffs, beispielsweise einer Annäherung und/oder einer Berührung, mithilfe der elektronischen Einheit ermöglicht werden.

Des Weiteren ist es im Rahmen der Erfindung vorteilhaft, dass die mindestens eine Leiterbahn und/oder die mindestens eine Sensoreinheit in Form eines Annäherungssensors, insbesondere eines kapazitiven Sensors, ausgeführt ist. Auf diese Weise kann eine Funktionalität des Türgriffes im Rahmen eines Keyless-Entry- und/oder Keyless-Go-Sicherheitssystems des Fahrzeuges ermöglicht werden.

Außerdem kann die Erfindung vorsehen, dass die elektronische Einheit mindestens eine Leuchteinheit aufweist, welche über das mindestens eine Steckerelement mit einer Steckerbuchse elektrisch verbindbar ist. Somit kann der Türgriff noch weitere vorteilhafte Funktionen bereitstellen, wenn die Leuchteinheit durch bestimmte Farben und/oder im Allgemeinen durch Aussenden von Licht bestimmte Betätigungszustände eines Keyless-Entry- und/oder Keyless-Go-Sicherheitssystems des Fahrzeuges signalisiert und/oder die Betätigung, wie z. B. Entriegelung und/oder Öffnung des beweglichen Teils andeutet. Außerdem ist es denkbar, dass die Leuchteinheit dazu ausgeführt sein kann, Warnsignale auszugeben, wenn bspw. durch die mindestens eine Sensoreinheit sensiert werden, dass der Benutzer und/oder weitere Hindernisse, wie z. B. Bordsteinkanten, oder Objekte, wie z. B. ein Baum oder eine Baumwurzel, zu nahe an dem beweglichen Teil steht, sodass eine ungefährliche Öffnung des beweglichen Teils nicht möglich ist.

Ferner kann die Erfindung vorsehen, dass der Türgriff als ein flächenbündiger Türgriff ausgeführt ist, und vorzugsweise von einer Ruhestellung, wobei in der Ruhestellung eine Außenfläche des Türgriffes im Wesentlichen bündig zu einer Außenseite des beweglichen Teils ist, in eine Betriebsstellung bewegbar ist, insbesondere durch eine parallele Bewegung der Außenfläche des Türgriffes zur Außenseite des beweglichen Teils, wobei in der Betriebsstellung der Türgriff manuell, bspw. durch Ziehen am Türgriff und/oder Drücken des Türgriffs, betätigbar ist. Somit können eine angenehme Optik und verbesserte Aerodynamik am Fahrzeug im Bereich des flächenbündigen Türgriffes bereitgestellt werden. Zugleich kann durch einen herausfahrbaren Türgriff, eine gewohnte und bequeme Betätigung des beweglichen Teils ermöglicht werden.

Weiterhin kann die Erfindung vorsehen, dass die elektrische Steckereinheit ein Steckergehäuse aufweist, wobei insbesondere in dem Steckergehäuse eine Aufnahme für das mindestens eine Steckerelement ausgebildet ist, sodass das mindestens eine Steckerelement durch mechanisches Verbinden des Steckergehäuses mit einer Steckerbuchse einer Lagerkupplung mit einer elektrischen Leitung, insbesondere einem Kabel, der Lagerkupplung elektrisch kontaktierbar ist. Auf diese Weise kann eine einfache Montage des Türgriffes am Fahrzeug und ein bequemes Anschließen der elektronischen Einheit mit der Fahrzeugelektronik sichergestellt werden.

Des Weiteren kann die Erfindung vorsehen, dass ein Steckergehäuse der elektrischen Steckereinheit mindestens ein Sicherungselement aufweist, um das Steckergehäuse form-und/oder kraftschlüssig mit einer Steckerbuchse einer Lagerkupplung zu verbinden, wobei insbesondere das mindestens eine Sicherungselement in Form einer Rastnase, eines Rasthakens oder eines Hinterschnitts für ein komplementäres Gegensicherungselement an einer Steckerbuchse einer Lagerkupplung ausgebildet ist. Auf diese Weise kann ein mechanisches sowie elektrisches Anschließen der elektrischen Steckereinheit an der Steckerbuchse einer Lagerkupplung einfach, bequem und zielgerichtet, bis zum Einrasten des Sicherungselements der elektrischen Steckereinheit am komplementären Gegensicherungselement der Lagerkupplung durchgeführt werden. Eine Endmontagestellung des Türgriffes an der Lagerkupplung kann somit haptisch durch Verrasten des Sicherungselements der elektrischen Steckereinheit am komplementären Gegensicherungselement der Lagerkupplung signalisiert werden.

Zudem kann die Erfindung vorsehen, dass ein Steckergehäuse der elektrischen Steckereinheit, insbesondere an dem mindestens einen Sicherungselement, ein zweites elastisches Abdichtelement aufweist, um insbesondere die Kavität zusätzlich zu einem ersten elastischen Abdichtelement abzudichten. Somit kann eine abgedichtete Aufnahme der elektronischen Einheit in der Kavität des Türgriffes sichergestellt werden.

Außerdem kann die Erfindung vorsehen, dass ein Steckergehäuse der elektrischen Steckereinheit als ein Kunststoff-Bauteil ausgeführt ist, insbesondere als ein Zweikomponenten-Spritzgussteil, vorzugsweise aus einem Faser-Kunststoff-Verbund. Mithin kann ein leichtes, kostengünstiges Bauteil mit verbesserten Eigenschaften bereitgestellt werden, welches schnell in Großer Stückzahl hergestellt werden kann.

Vorteilhafterweise kann ein Steckergehäuse der elektrischen Steckereinheit das mindestens eine Steckerelement als ein eingespritztes Element aufweisen. Somit kann das mindestens eine Steckerelement sich von der Kavität über das Steckergehäuse nach außen führen und für die elektrische Verbindung mit einer Fahrzeugelektronik dienen.

Ferner kann die Erfindung vorsehen, dass der Türgriff eine Lagerarmaufnahme für eine Lagerkupplung aufweist, die insbesondere eine vollständig geschlossene Umfangskontur für die Lagerkupplung aufweist, die vorzugsweise an den Außenumfang der Lagerkupplung angepasst ist, und die bevorzugt O-förmig oder im Wesentlichen rechteckförmig ausgebildet ist. Auf diese Weise kann eine vereinfachte Aufnahme der Lagerkupplung in einem Lagerarm des Türgriffes ermöglicht werden. Die Lagerarmaufnahme kann dabei quasi durch den Lagerarm des Türgriffes gebildet werden.

Weiterhin kann die Erfindung vorsehen, dass die Lagerarmaufnahme ein Montageelement, insbesondere in Form einer Führungsschiene oder eines Führungsrastelementes, für ein komplementäres Gegenmontageelement der Lagerkupplung aufweist, um die Lagerkupplung in einer definierten Ausrichtung in der Lagerarmaufnahme aufzunehmen. Auf diese Weise werden Montagefehler sicher vermieden. Der Türgriff wird mithilfe des Montageelementes stets in der vorgegebenen Position am beweglichen Teil befestigt. Außerdem wird mithilfe des Montageelementes zuverlässiger elektrischer Kontakt der elektronischen Einheit mit der Lagerkupplung gewährleistet.

Des Weiteren kann die Erfindung vorsehen, dass die Lagerarmaufnahme derart beabstandet zur Außenkontur der elektrischen Steckereinheit ausgeführt ist, dass die elektrische Steckereinheit durch die Lagerarmaufnahme hülsenförmig umschlossen ist, und dass die Lagerarmaufnahme mit der Steckereinheit einen männlichen Steckerteil bilden, in welchem eine Steckerbuchse einer Lagerkupplung lösbar, insbesondere form- und/oder kraftschlüssig, aufnehmbar und elektrisch kontaktierbar ist. Auf diese Weise kann eine intuitive Montage der Steckerbuchse der Lagerkupplung in der Lagerarmaufnahme nach dem Prinzip Stecker und Steckdose ermöglicht werden.

Zudem kann die Erfindung vorsehen, dass der Türgriff im Bereich zwischen dem Gehäuse und einer Lagerarmaufnahme für eine Lagerkupplung eine Befestigungseinheit für ein Steckergehäuse der elektrischen Steckereinheit aufweist. Auf diese Weise kann die elektrische Steckereinheit verlierfest und rutschfrei innerhalb des Türgriffes befestigt werden, sodass insbesondere über die elektrische Steckereinheit auch die Befestigung des Türgriffes an der Lagerkupplung ermöglicht werden kann.

Außerdem kann die Erfindung vorsehen, dass die Befestigungseinheit eine Labyrinthführung aufweist, die vorzugsweise mit einer komplementären umfangseitigen Schulter der elektrischen Steckereinheit zusammenwirkt. Mithilfe der Labyrinthführung kann eine einfache Befestigung der elektrischen Steckereinheit im Gehäuse ermöglicht werden, wobei die richtige Montagebewegung und Montageposition durch die Labyrinthführung vorgegeben werden. Außerdem kann durch Labyrinthführung eine Abdichtung der Kavität ermöglicht werden.

Denkbar ist es ferner, dass die Befestigungseinheit eine zusätzliche Dichtung, insbesondere innerhalb der Labyrinthführung, zur Abdichtung der Kavität aufweisen kann. Auf diese Weise kann die Abdichtung der Kavität und insbesondere der elektronischen Einheit innerhalb des Türgriffes erheblich verbessert werden.

Weiterhin ist es denkbar, dass die Befestigungseinheit sich vorzugsweise entlang eines äußeren Umfangs des Steckergehäuses der elektrischen Steckereinheit erstreckt. Auf diese Weise kann die elektrische Steckereinheit die Lageraufnahme quasi wie ein Stopfen abschließen. Mit einer zusätzlichen Dichtwirkung der Befestigungseinheit kann eine zuverlässige abgedichtete Kavität innerhalb des Türgriffes geschaffen werden.

Des Weiteren ist es denkbar, dass das Gehäuse des Türgriffs eine erste Schale und eine zweite Schale aufweist. Somit kann eine einfache Montage und/oder Anordnung und/oder Positionierung der elektronischen Einheit, insbesondere der Trägereinheit, innerhalb der Kavität des Türgriffs in einer der Schalen ermöglicht werden, wobei die andere Schale nach danach an der ersten Schale befestigt werden kann, um die Kavität zu bilden.

Zudem ist es denkbar, dass das Gehäuse mindestens ein Positionierungselement, insbesondere in Form einer Positionierungsschiene, für die Trägereinheit aufweist, um die Trägereinheit in der Kavität zu fixieren. Auf diese Weise kann die richtige Montage und/oder Anordnung und/oder Positionierung der elektronischen Einheit, insbesondere der Trägereinheit, innerhalb der Kavität des Türgriffs sichergestellt werden.

Zudem ist es denkbar, dass das Gehäuse, insbesondere umfassend eine Lagerarmaufnahme für eine Lagerkupplung und/oder eine Befestigungseinheit für ein Steckergehäuse der elektrischen Steckereinheit, zur Abdichtung der Kavität ausgeführt ist, um insbesondere ein Ausdringen einer Vergussmasse aus der Kavität zu verhindern. Somit kann die Vergussmasse in die Kavität eingegossen werden, um die elektronische Einheit noch besser zu schützen.

Mit anderen Worten ist es denkbar, dass in der Kavität eine Vergussmasse eingespritzt ist, um insbesondere die elektronische Einheit abzudichten, wobei vorzugsweise die Vergussmasse die elektronische Einheit überwiegend oder vollständig umgibt. Durch die Vergussmasse kann eine verbesserte Abdichtung der elektronischen Einheit ermöglicht werden.

Ferner kann die Erfindung vorsehen, dass das Gehäuse des Türgriffs, insbesondere eine erste Schale und eine zweite Schale, eine Öffnung zum Einspritzen einer Vergussmasse in die Kavität aufweist. Somit kann ein Eingießen der Vergussmasse in die Kavität nach der Anordnung der elektronischen Einheit innerhalb der Kavität des Türgriffs und nach dem Schließen einer der Schalen mit der anderen Schale des Gehäuses durchgeführt werden.

Weiterhin kann die Erfindung vorsehen, dass das Gehäuse, insbesondere eine Lagerarmaufnahme für eine Lagerkupplung und/oder eine Befestigungseinheit für ein Steckergehäuse der elektrischen Steckereinheit, eine Wandung, insbesondere mit einem ersten elastischen Abdichtelement, aufweist, wobei vorzugsweise die Wandung die Kavität von einer Lagerarmaufnahme für eine Lagerkupplung abgrenzt, wobei bevorzugt sich das mindestens eine Steckerelement durch die Wandung hindurch von der Kavität zu einer Lagerarmaufnahme für eine Lagerkupplung erstreckt. Auf diese Weise kann eine abdichtende Trennung zwischen dem Bereich innerhalb des Türgriffes bzw. der Kavität und dem Bereich außerhalb des Türgriffes ermöglicht werden.

Des Weiteren kann die Erfindung eine Blende für die elektronische Einheit vorsehen, welche insbesondere an einer Außenseite des Türgriffes, bspw. einer dem beweglichen Teil abgewandten Seite, angeordnet ist, um mindestens eine Sensoreinheit der elektronischen Einheit abzuschirmen und/oder einen Detektionsbereich der mindestens einen Sensoreinheit zu formen. Auf diese Weise kann die Funktionalität der Sensoreinheit verbessert werden.

Zudem ist es denkbar, dass die Blende elektrisch leitfähig und/oder metallisch und/oder als eine Beschichtung, bspw. eine Chrombeschichtung, an der Außenseite des Türgriffs ausgebildet sein kann. Somit kann eine einfache Herstellung der Blende ermöglicht werden. Außerdem ist es denkbar, dass die Blende mit der elektrischen Einheit elektrisch verbunden sein kann. Auf diese Weise kann die Blende eine weitere Sensoreinheit im Sinne der Erfindung bereitstellen und/oder an ein bestimmtes Potential angeschlossen werden. Mithin kann die Funktionalität des erfindungsgemäßen Türgriffes erweitert werden. Bspw. kann die Blende zum Detektieren einer Annährung auf Distanz ausgeführt sein. Weiterhin ist es denkbar, dass diese oder eine weitere Blende zum Detektieren einer Berührung, bspw. als Teil eines induktiven Sensors, ausgeführt sein kann.

Ferner wird die erfindungsgemäße Aufgabe durch eine Griffanordnung für ein Fahrzeug gelöst, aufweisend: einen Türgriff, welcher wie oben beschrieben ausgeführt ist, und eine Lagerkupplung zum Befestigen des Türgriffes am Fahrzeug, bspw. an einem Montageträger des Fahrzeuges, wobei die Lagerkupplung mit einer elektrischen Leitung, insbesondere einem Kabel, ausgeführt ist, und wobei die Lagerkupplung mit einer elektrischen Steckereinheit des Türgriffes mechanisch, insbesondere lösbar, vorzugsweise form- und/oder kraftschlüssig, befestigt und elektrisch verbunden ist. Der Montageträger kann weiterhin einen zentralen Stecker aufweisen, der wiederum an die Fahrzeugelektronik elektrisch angeschlossen sein kann. Mithilfe der erfindungsgemäßen Griffanordnung können die gleichen Vorteile gelöst, die oben im Zusammenhang mit dem erfindungsgemäßen Türgriff beschrieben wurden. Auf diese Vorteile wird vorliegend vollumfänglich Bezug genommen.

Wie oben bereits im Zusammenhang mit dem erfindungsgemäßen Türgriff beschrieben wurde, kann der Türgriff eine Lagerarmaufnahme für die Lagerkupplung aufweisen, die insbesondere eine vollständig geschlossene Umfangskontur für die Lagerkupplung aufweist, die vorzugsweise an den Außenumfang der Lagerkupplung angepasst ist, und die bevorzugt O-förmig oder im Wesentlichen rechteckförmig ausgebildet ist. Mithilfe der Lagerarmaufnahme für die Lagerkupplung kann eine intuitive Montage des Türgriffes an der Lagerkupplung ermöglicht werden.

Weiterhin kann die Erfindung vorsehen, dass die Lagerarmaufnahme ein Montageelement, insbesondere in Form einer Führungsschiene oder eines Führungsrastelementes aufweist, die oder das mit einem komplementären Kupplungselement der Lagerkupplung zusammenwirkt, um die Lagerkupplung in einer definierten Ausrichtung in der Lagerarmaufnahme aufzunehmen. Au diese Weise kann eine richtige Montage des Türgriffes an der Lagerkupplung sichergestellt werden.

Des Weiteren kann die Erfindung vorsehen, dass die Lagerarmaufnahme derart beabstandet zur Außenkontur der elektrischen Steckereinheit ausgeführt ist, dass die elektrische Steckereinheit durch die Lagerarmaufnahme hülsenförmig umschlossen ist, und dass die Lagerarmaufnahme mit der Steckereinheit einen männlichen Steckerteil bilden, in welchem eine Steckerbuchse der Lagerkupplung lösbar, insbesondere form- und/oder kraftschlüssig, aufgenommen und elektrisch kontaktiert ist. Somit können Fehler bei der Montage sicher vermieden werden, weil die elektrische Steckereinheit innerhalb der Lagerarmaufnahme ein passendes Gegenstück für die Steckerbuchse der Lagerkupplung bilden kann.

Zudem kann die Erfindung vorsehen, dass ein Steckergehäuse der elektrischen Steckereinheit mindestens ein Sicherungselement aufweist, um das Steckergehäuse form-und/oder kraftschlüssig mit einer Steckerbuchse der Lagerkupplung zu verbinden, wobei insbesondere das mindestens eine Sicherungselement in Form einer Rastnase, eines Rasthakens oder eines Hinterschnitts ausgebildet ist, welche oder welcher mit einem komplementären Gegensicherungselement an einer Steckerbuchse der Lagerkupplung zusammenwirkt. Somit kann die erreichte Endmontagestellung des Türgriffes an der Lagerkupplung durch Verrasten des Sicherungselements der elektrischen Steckereinheit am komplementären Gegensicherungselement der Lagerkupplung haptisch signalisiert werden. Außerdem wird die erfindungsgemäße Aufgabe durch ein Verfahren zur Herstellung einer Griffanordnung (umfassend den Zusammenbau des Türgriffes und die Montage des Türgriffes am Fahrzeug) für ein Fahrzeug gelöst, welche wie oben beschrieben ausgeführt ist, aufweisend folgende Schritte:
1) Einbringen einer elektronischen Einheit in eine Kavität eines Türgriffs, wobei die elektronische Einheit eine Trägereinheit und eine elektrische Steckereinheit aufweist,
2) Einbringen einer Vergussmasse in die Kavität, sodass die Vergussmasse die elektronische Einheit zumindest teilweise umgibt,
3) Befestigen einer Lagerkupplung, die mit einer elektrischen Leitung, insbesondere einem Kabel, ausgeführt ist, an der elektrischen Steckereinheit, wodurch der Türgriff am Fahrzeug, insbesondere an einem Montageträger des Fahrzeuges, mechanisch, insbesondere lösbar, vorzugsweise form- und/oder kraftschlüssig, befestigt wird und zugleich die elektronische Einheit mit der elektrischen Leitung der Lagerkupplung elektrisch verbunden wird.

Mithilfe des erfindungsgemäßen Verfahrens können die gleichen Vorteile erreicht werden, die oben im Zusammenhang mit dem erfindungsgemäßen Türgriff und/oder der erfindungsgemäßen Griffanordnung beschrieben wurden. Auf diese Vorteile wird vorliegend vollumfänglich Bezug genommen.

Ferner kann die Erfindung bei einem Verfahren zur Herstellung einer Griffanordnung vorsehen, dass im Schritt 1) das Einbringen der elektronischen Einheit in die Kavität zumindest teilweise automatisch oder vollautomatisch, vorzugsweise über einen Roboter, erfolgt. Mithin kann das Verfahren deutlich beschleunigt werden und wesentliche Kostenvorteile mit sich bringen.

Weiterhin kann die Erfindung bei einem Verfahren zur Herstellung einer Griffanordnung vorsehen, dass im Schritt 1) eine automatische Positionierung der elektronischen Einheit durch mindestens ein Positionierungselement am Gehäuse, insbesondere in Form einer Positionierungsschiene, durchgeführt wird. Somit kann die Richtigkeit bei der Anordnung Positionierung der elektronischen Einheit in der Kavität gewährleistet werden.

Des Weiteren kann die Erfindung bei einem Verfahren zur Herstellung einer Griffanordnung vorsehen, dass im Schritt 1) eine automatische Positionierung und/oder eine automatische Abdichtung der elektronischen Einheit durch eine Befestigungseinheit für ein Steckergehäuse der elektrischen Steckereinheit, insbesondere in Form einer Labyrinthführung, durchgeführt wird, und/oder dass im Schritt 3) eine zusätzliche Abdichtung der elektronischen Einheit durch ein Steckergehäuse der elektrischen Steckereinheit, insbesondere durch ein zweites elastisches Abdichtelement an mindestens einem Sicherungselement des Steckergehäuses, durchgeführt wird. Auf diese Weise kann ein verbesserter Türgriff und eine verbesserte Griffanordnung bereitgestellt werden, die über eine zuverlässige Funktionalität und eine verlängerte Betriebsdauer verfügen können. Zudem kann die Erfindung bei einem Verfahren zur Herstellung einer Griffanordnung vorsehen, dass das Verfahren mindestens einen weiteren Schritt aufweist:
4) Verschrauben der Lagerkupplung an einer Lageraufnahme des Türgriffes.

Somit kann die verlierfeste Befestigung des Türgriffes an der Lagerkupplung und somit am Fahrzeug noch weiter gesichert werden.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Es zeigen:
- Figur 1: eine Explosionsdarstellung eines Lagerarms eines erfindungsgemäßen Türgriffes und einer Lagerkupplung für den erfindungsgemäßen Türgriff,
- Figur 2: eine schematische Darstellung eines Lagerarms eines erfindungsgemäßen Türgriffes und einer Lagerkupplung im zusammengebauten Zustand im Längsschnitt durch den Türgriff,
- Figur 3: eine schematische Darstellung eines Lagerarms eines erfindungsgemäßen Türgriffes und einer Lagerkupplung in einem zusammengebauten Zustand im Querschnitt durch den Türgriff entlang des Lagerarms,
- Figur 4: eine schematische Darstellung eines Fahrzeuges mit einem erfindungsgemäßen Türgriff,
- Figur 5: eine perspektivische Darstellung eines erfindungsgemäßen Türgriffs im zusammengebauten Zustand,
- Figur 6: eine Explosionsdarstellung eines erfindungsgemäßen Türgriffs, und
- Figur 7: eine schematische Darstellung eines fahrzeugseitigen Montageträgers für einen erfindungsgemäßen Türgriff in einer Explosionsdarstellung.

In den nachfolgenden Figuren werden für die gleichen technischen Merkmale auch von unterschiedlichen Ausführungsbeispielen die identischen Bezugszeichen verwendet.

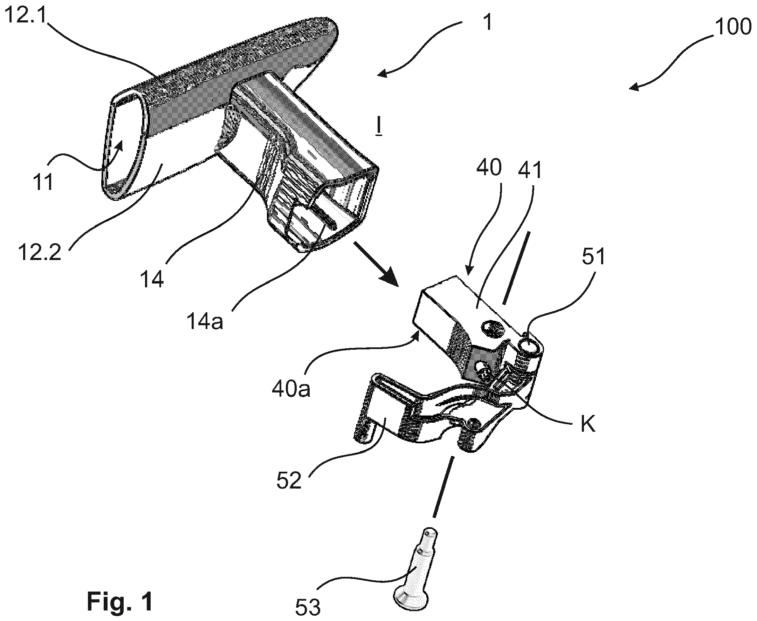

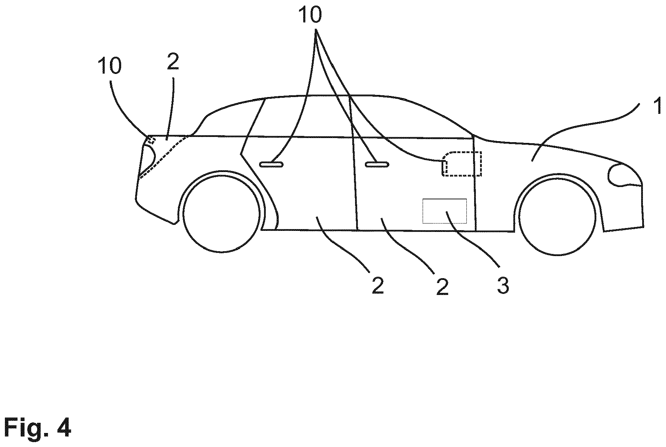

Die Figuren 1 bis 3 zeigen jeweils einen Abschnitt eines erfindungsgemäßen Türgriffs 10 an einer ersten Lagerstelle I vor einer Befestigung mit einer Lagerkupplung 40 in unterschiedlichen Darstellungen. Der Türgriff 10 ist für ein Fahrzeug 1, vorzugsweise ein Kraftfahrzeug, insbesondere als ein Türaußengriff für ein bewegliches Teil 2 des Fahrzeuges 1 ausgebildet. Das Fahrzeug 1 ist schematisch in der Figur 4 gezeigt.

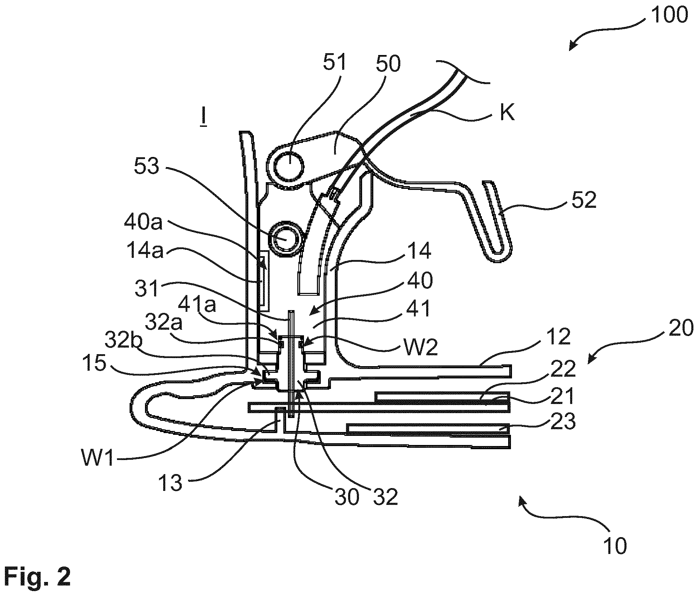

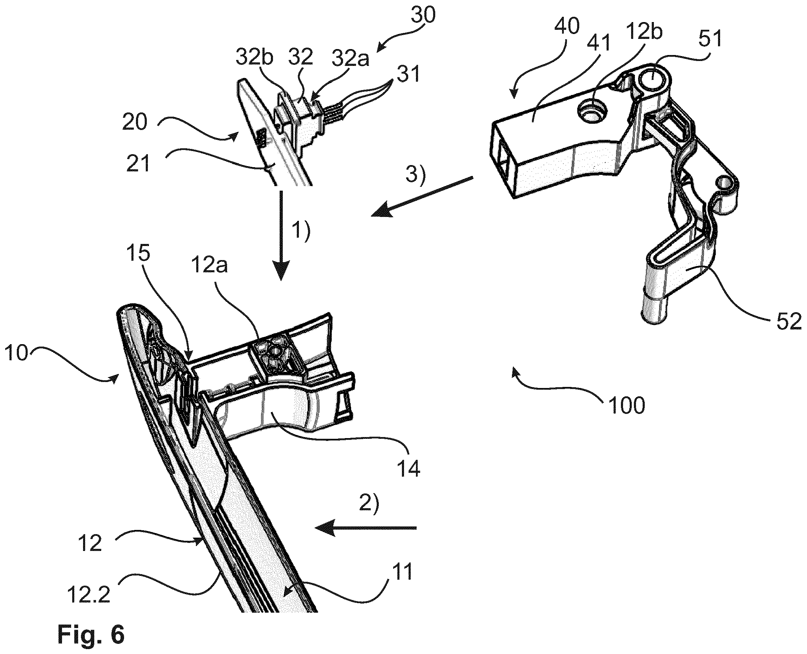

Der Türgriff 10 weist folgende Elemente auf:
- eine Kavität 11, welche zumindest teilweise durch ein Gehäuse 12 des Türgriffs 10 gebildet ist, und
- eine elektronische Einheit 20, welche in der Kavität 11 aufgenommen ist,
wobei die elektronische Einheit 20 eine Trägereinheit 21, insbesondere eine elektrische Platine, wie z. B. Leiterplatte oder gedruckte Schaltung, aufweist,
- eine elektrische Steckereinheit 30, welche mindestens ein elektrisch leitendes Steckerelement 31, insbesondere umfassend mindestens einen Kontaktstift (vgl. die Figur 2) oder mehrere Kontaktstifte, z. B. drei Kontaktstifte (vgl. die Figur 6), aufweist,
wobei das mindestens eine Steckerelement 31 an der Trägereinheit 21 stoffschlüssig befestigt, insbesondere gelötet, geschweißt oder geklebt, ist.

Der Türgriff 10 kann im Rahmen der Erfindung als ein flächenbündiger Türgriff 10 ausgebildet sein, welcher zum Erreichen einer nicht gezeigten Betriebsstellung aus der Außenseite des beweglichen Teils 2 herausfahrbar ist. In der Betriebsstellung dient der Türgriff 10 zur Betätigung des beweglichen Teils 2, bspw. zum Entriegeln und/oder Öffnen des beweglichen Teils 2. Zur Betätigung des Türgriffs 10 kann z. B. eine Kraftausübung, bspw. ein Ziehen und/oder Drücken, am Türgriff 10 erfolgen. Der Türgriff 10 kann vorteilhafterweise für ein Keyless-Entry- und/oder Keyless-Go-Sicherheitssystem vorgesehen sein.

Die Trägereinheit 21 im Sinne der Erfindung ist zur Aufnahme von elektronischen Bauelementen ausgeführt. Ferner kann die Trägereinheit 21 auch zur Aufnahme eines Mikroprozessors und/oder eines integrierten Schaltkreises sowie einer oder mehreren Sensoreinheiten 22 und/oder einer oder mehreren Leiterbahnen ausgeführt sein.

Das mindestens eine elektrisch leitende Steckerelement 31, insbesondere in Form von mindestens einem Kontaktstift, ist vorzugsweise stoffschlüssig mit der Trägereinheit 21 verbunden, bspw. durch Löten, Schweißen und/oder Kleben.

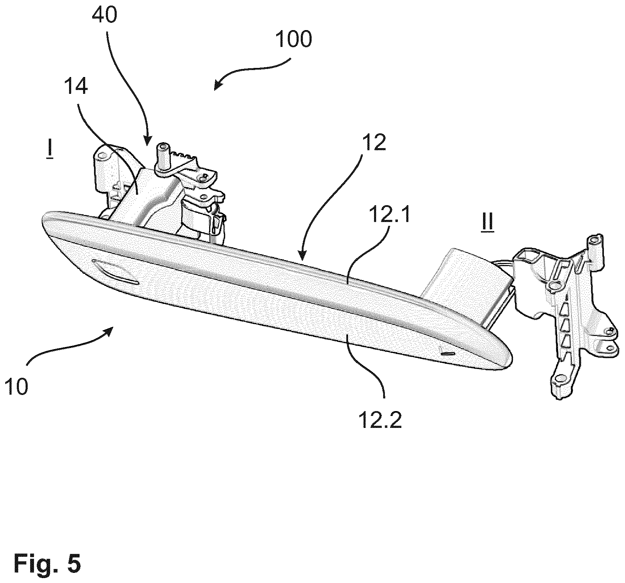

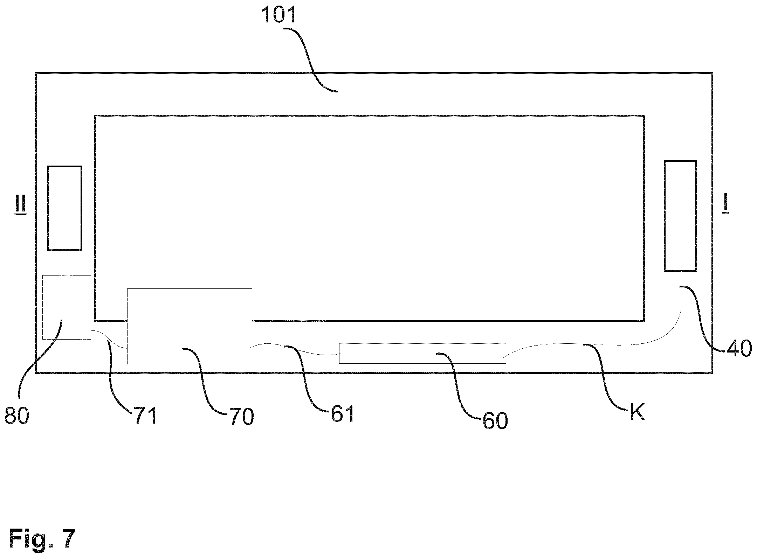

Wie es aus den Figuren 2 und 6 erkennbar ist, kann das mindestens eine elektrisch leitende Steckerelement 31 zusammen mit der elektrischen Steckereinheit 30 einen männlichen Steckerteil bilden, welcher im Türgriff 10, insbesondere in einem Lagerarm des Türgriffes 10, bspw. in Form einer Lageraufnahme 12, integriert ist. Somit kann der Türgriff 10, wie es in der Figur 5 angedeutet ist, ohne ein Kabel bereitgestellt werden und nur durch die Montage des Türgriffes 10 am Fahrzeug 1 elektrisch an eine elektrische Leitung K angeschlossen werden, die wiederum zu einem weiteren Schalter 60 und/oder zu einer Steuereinheit 70 führen kann, wie es in der Figur 7 angedeutet ist.

Wie es in der Figur 6 gezeigt ist, kann nach dem Anordnen des Türgriffes 10 von außen am Fahrzeug 1, insbesondere am beweglichen Teil 2 des Fahrzeuges 1, von innen bzgl. des Fahrzeuges 1 bzw. von innen bzgl. des beweglichen Teils 2 des Fahrzeuges 1 gesehen eine separate Steckerbuchse 41 zum Steckerelement 31 geführt werden, die an der elektrischen Steckereinheit 30 mechanisch befestigt und zugleich mit dem mindestens einen elektrisch leitenden Steckerelement 31 elektrisch verbunden werden kann.

Die Steckerbuchse 41 kann wiederum, wie es in der Figur 2 gezeigt ist, mit einer elektrischen Leitung K, bspw. in Form eines Kabels ausgeführt sein, welche bzw. welches zu einer Elektronik des Fahrzeuges führen kann, ggf. über einen weiteren Zentralstecker 60 und/oder über eine Steuereinheit 70 an einem Montageträger 101 (vgl. die Figur 7). Die Montage des Türgriffes 10 am Fahrzeug 1, insbesondere am beweglichen Teil 2 des Fahrzeuges 1, sowie die Verschaltung der elektronischen Einheit 20 mit der Elektronik des Fahrzeuges 1 kann somit erheblich vereinfacht werden.

Ferner brauchen/braucht die elektronische Einheit 20 und/oder die elektrische Steckereinheit 30 von vornherein, bspw. beim Herstellen des Türgriffes 10, d. h. beim Einsetzen der elektronischen Einheit 20 und/oder der elektrischen Steckereinheit 30 in die Kavität 11, nicht mit einem Kabel gehandhabt werden. Die Montage der elektronischen Einheit 20, insbesondere der Trägereinheit 21, und/oder der elektrischen Steckereinheit 30 innerhalb der Kavität 11 des Türgriffs 10 können/kann damit deutlich vereinfacht werden. Vorteilhafterweise kann somit ein einfacher und automatisierter Zusammenbau des Türgriffes, sogar durch einen Roboter, ermöglicht werden.

Wie es aus den Figuren 1, 2, 5 und 6 erkennbar ist, können/kann die elektrische Steckereinheit 20 und/oder die elektronische Einheit 20, bzw. der Türgriff 10 selbst, kabellos ausgeführt sein. Nach dem Zusammenbau des Türgriffes 10 kann ein fertiger kabelloser Türgriff 10 von außen zum beweglichen Teil 2 des Fahrzeugs 1 geführt werden, um an einer Lagerkupplung 40 montiert zu werden, die von innen zum beweglichen Teil 2 des Fahrzeugs 1 geführt werden kann. Die Lagerkupplung 40 kann wiederum eine elektrische Leitung K, insbesondere ein Kabel, aufweisen, die mit der elektrischen Steckereinheit 30 mechanisch, insbesondere lösbar, vorzugsweise form- und/oder kraftschlüssig, bevorzugt durch eine Rastverbindung 32a, 41a, befestigbar werden kann, wodurch die elektronische Einheit 20 mit der elektrischen Leitung K, insbesondere dem Kabel, der Lagerkupplung 40 elektrisch verbunden werden kann.

Wie in der Figur 2 angedeutet ist, kann die Trägereinheit 21 mindestens eine Leiterbahn und/oder mindestens eine Sensoreinheit 22 aufweisen, welche über das mindestens eine Steckerelement 31 mit einer Steckerbuchse 41 elektrisch verbindbar sind/ist. Die mindestens eine Leiterbahn und/oder die mindestens eine Sensoreinheit 22 können vorteilhafterweise in Form eines Annäherungssensors, insbesondere eines kapazitiven Sensors, ausgeführt sein, um eine berührungslose Betätigung des Türgriffes 10 zu ermöglichen. Somit kann der Türgriff 10 ein Teil eines Keyless-Entry- und/oder Keyless-Go-Sicherheitssystems des Fahrzeuges 1 bilden.

An der elektronischen Einheit 20 kann weiterhin mindestens eine (nicht gezeigte) Leuchteinheit vorgesehen sein, welche über das mindestens eine Steckerelement 31 mit einer Steckerbuchse 41 elektrisch verbindbar ist. Die Leuchteinheit kann bspw. durch bestimmte Farben und/oder im Allgemeinen durch Aussenden von Licht bestimmte Betätigungszustände eines Keyless-Entry- und/oder Keyless-Go-Sicherheitssystems des Fahrzeuges 1 und/oder die Betätigung, wie z. B. Entriegelung und/oder Öffnung des beweglichen Teils 2 signalisieren. Außerdem kann die Leuchteinheit Warnsignale ausgeben, wenn bspw. durch die mindestens eine Sensoreinheit 22 sensiert wird, dass der Benutzer und/oder weitere Hindernisse, wie z. B. Bordsteinkanten, oder Objekte, wie z. B. ein Baum oder eine Baumwurzel, zu nahe an dem beweglichen Teil 2 sich befinden, sodass eine ungefährliche Öffnung des beweglichen Teils 2 nicht möglich ist.

Wie es weiterhin die Figuren 2, 3 und 6 zeigen, kann die elektrische Steckereinheit 30 ein Steckergehäuse 32 aufweisen, wobei insbesondere in dem Steckergehäuse 32 eine Aufnahme für das mindestens eine Steckerelement 31 ausgebildet ist, sodass das mindestens eine Steckerelement 31 durch mechanisches Verbinden des Steckergehäuses 32 mit einer Steckerbuchse 41 einer Lagerkupplung 40 mit einer elektrischen Leitung K, insbesondere einem Kabel, der Lagerkupplung 40 elektrisch kontaktierbar ist.

Des Weiteren zeigen die Figuren 2, 3 und 6, dass das Steckergehäuse 32 der elektrischen Steckereinheit 30 mindestens ein Sicherungselement 32a aufweisen kann, um das Steckergehäuse 32 form- und/oder kraftschlüssig mit der Steckerbuchse 41 der Lagerkupplung 40 zu verbinden, wobei insbesondere das mindestens eine Sicherungselement 32a in Form einer Rastnase, eines Rasthakens oder eines Hinterschnitts für ein komplementäres Gegensicherungselement 41a an der Steckerbuchse 41 der Lagerkupplung 40 ausgebildet sein kann.

Wie es in der Figur 2 angedeutet ist, kann das Steckergehäuse 32 der elektrischen Steckereinheit 20, insbesondere an dem mindestens einen Sicherungselement 32a, ein zweites elastisches Abdichtelement W2 aufweisen, um insbesondere die Kavität 11 zusätzlich zu einem ersten elastischen Abdichtelement W1 abzudichten, auf den im Nachfolgenden eingegangen wird.

Das Steckergehäuse 32 der elektrischen Steckereinheit 30 kann dabei als ein Kunststoff-Bauteil ausgeführt sein, bspw. als ein Zweikomponenten-Spritzgussteil, vorzugsweise aus einem Faser-Kunststoff-Verbund. Ferner ist es denkbar, dass das Steckergehäuse 32 der elektrischen Steckereinheit 30 das mindestens eine Steckerelement 31 als ein eingespritztes Element aufweisen kann.

Wie es die Figuren 1 bis 3, 5 und 6 zeigen, kann der Türgriff 10 eine Lagerarmaufnahme 14 für die Lagerkupplung 40 aufweisen, die insbesondere eine vollständig geschlossene Umfangskontur für die Lagerkupplung 40 aufweist, die vorzugsweise an den Außenumfang der Lagerkupplung 40 angepasst ist, und die bevorzugt O-förmig oder im Wesentlichen rechteckförmig ausgebildet ist. Die Lagerkupplung 40 bildet zusammen mit dem Türgriff 10 eine Griffanordnung 100 im Sinne der Erfindung.

Die Lagerarmaufnahme 14 kann vorteilhafterweise ein Montageelement 14a aufweisen, welches in der Figur 2 angedeutet ist. Das Montageelement 14a kann in Form einer Führungsschiene oder eines Führungsrastelementes für ein komplementäres Gegenmontageelement 40a der Lagerkupplung 40 ausgebildet sein, um die Lagerkupplung 40 in einer definierten Ausrichtung in der Lagerarmaufnahme 14 aufzunehmen.

Wie es ferner aus der Figur 2 ersichtlich ist, kann die Lagerarmaufnahme 14 derart beabstandet zur Außenkontur der elektrische Steckereinheit 30 ausgeführt sein, dass die elektrische Steckereinheit 30 durch die Lagerarmaufnahme 14 hülsenförmig umschlossen ist, und dass die Lagerarmaufnahme 14 mit der Steckereinheit 30 einen männlichen Steckerteil bilden, in welchem die Steckerbuchse 41 einer Lagerkupplung 40 lösbar, insbesondere form- und/oder kraftschlüssig, befestigbar ist. Auf diese Weise kann eine intuitive Montage der Steckerbuchse 41 der Lagerkupplung 40 in der Lagerarmaufnahme 14 nach dem Prinzip Stecker und Steckdose ermöglicht werden.

Wie es ferner in den Figuren 2 und 6 gezeigt ist, kann der Türgriff 10 im Bereich zwischen dem Gehäuse 12 und einer Lagerarmaufnahme 14 für eine Lagerkupplung 40 eine Befestigungseinheit 15 für ein Steckergehäuse 32 der elektrischen Steckereinheit 30 aufweisen. Die Befestigungseinheit 15 kann in Form einer Labyrinthführung ausgebildet sein, die vorzugsweise mit einer komplementären umfangseitigen Schulter 32b der elektrischen Steckereinheit 30 zusammenwirkt. Mithilfe der Labyrinthführung kann eine einfache Befestigung der elektrischen Steckereinheit 30 im Gehäuse 12 des Türgriffes 10 ermöglicht werden, wobei die richtige Montagebewegung und Montageposition der elektrischen Steckereinheit 30 im Gehäuse 12 des Türgriffes 10 durch die Labyrinthführung vorgegeben werden. Außerdem dient die Labyrinthführung zur Abdichtung der Kavität 11. Zudem ist es denkbar, dass die Befestigungseinheit 15 eine zusätzliche Dichtung, insbesondere innerhalb der Labyrinthführung, zur Abdichtung der Kavität 11 aufweisen kann.

Wie es aus den Figuren 2 und 6 ersichtlich ist, kann sich die Befestigungseinheit 15 vorzugsweise entlang eines äußeren Umfangs des Steckergehäuses 32 der elektrischen Steckereinheit 30 erstrecken.

Wie es die Figuren 1 bis 3, 5 und 6 andeuten, kann das Gehäuse 12 des Türgriffs 10 eine erste Schale 12.1 und eine zweite Schale 12.2 aufweisen, um eine einfache Montage und/oder Anordnung und/oder Positionierung der elektronischen Einheit 20, insbesondere der Trägereinheit 21, innerhalb der Kavität 11 des Türgriffs 10 zu ermöglichen.

Das Gehäuse 12 kann ferner mindestens ein Positionierungselement 13, bspw. in Form einer Positionierungsschiene, für die Trägereinheit 21 aufweisen, um die Trägereinheit 21 in der Kavität 11 bei der Montage zu führen und in einer richtigen Montagestellung zu fixieren.

In die Kavität 11 kann im Rahmen der Erfindung eine Vergussmasse eingespritzt werden, um insbesondere die elektronische Einheit 20 abzudichten, wobei vorzugsweise die Vergussmasse die elektronische Einheit 20 überwiegend oder vollständig umgibt. Hierzu kann das Gehäuse 12 des Türgriffs 10, insbesondere die erste Schale 12.1 und/oder die zweite Schale 12.2, eine (nicht gezeigte) Öffnung zum Einspritzen einer Vergussmasse in die Kavität 11 aufweisen.

Das Gehäuse 12, insbesondere im unteren Bereich der Lagerarmaufnahme 14 für die Lagerkupplung 40, vorzugsweise unterhalb der Befestigungseinheit 15 für das Steckergehäuse 32 der elektrischen Steckereinheit 30, eine Wandung W, vorzugsweise mit einem ersten elastischen Abdichtelement W1, aufweisen (siehe hierzu die Figur 2). Die Wandung W kann dabei die Kavität 11 von der Lagerarmaufnahme 14 für die Lagerkupplung 40 abgrenzen, wobei bevorzugt sich das mindestens eine Steckerelement 31 durch die Wandung W hindurch von der Kavität 11 zu der Lagerarmaufnahme 14 für die Lagerkupplung 40 erstrecken kann.

Wie es in der Figur 2 angedeutet ist, kann die Erfindung eine Blende 23 für die elektronische Einheit 20 vorsehen, welche insbesondere von innen an einer Außenseite des Türgriffes 10, bspw. einer dem beweglichen Teil 2 abgewandten Seite, angeordnet sein kann, um die mindestens eine Sensoreinheit 22 der elektronischen Einheit 20 abzuschirmen und/oder einen Detektionsbereich der mindestens einen Sensoreinheit 22 zu formen. Die Blende 23 kann elektrisch leitfähig und/oder metallisch und/oder als eine Beschichtung, bspw. eine Chrombeschichtung, an der Außenseite des Türgriffs 10 ausgebildet sein. Außerdem ist es denkbar, dass die Blende 23 mit der elektrischen Einheit 20 elektrisch verbunden sein kann, um selbst als eine Sensoreinheit zu dienen.

Die Figuren 6 und 7 können dazu dienen, das erfindungsgemäße Verfahren zur Herstellung einer Griffanordnung 100 (umfassend den Zusammenbau des Türgriffes 10 und die Montage des Türgriffes 10 am Fahrzeug 1) für ein Fahrzeug 1 zu erklären. Das erfindungsgemäße Verfahren weist folgende Schritte auf, die in der Figur 6 angedeutet sind:
1) Einbringen einer elektronischen Einheit 20 in eine Kavität 11 eines Türgriffs 10, wobei die elektronische Einheit 20 eine Trägereinheit 21 und eine elektrische Steckereinheit 30 aufweist,
2) Einbringen einer Vergussmasse in die Kavität 11, sodass die Vergussmasse die elektronische Einheit 20 zumindest teilweise umgibt,
3) Befestigen einer Lagerkupplung 40, die mit einer elektrischen Leitung K, insbesondere einem Kabel, ausgeführt ist, an der elektrischen Steckereinheit 30, wodurch der Türgriff 10 am Fahrzeug 1, insbesondere an einem Montageträger 101 des Fahrzeuges 1, mechanisch, insbesondere lösbar, vorzugsweise form- und/oder kraftschlüssig, befestigt wird und zugleich die elektronische Einheit 20 mit der elektrischen Leitung K der Lagerkupplung 40 elektrisch verbunden wird.

Im Schritt 1) kann das Einbringen der elektronischen Einheit 20 in die Kavität 11 zumindest teilweise automatisch oder vollautomatisch, vorzugsweise über einen Roboter, erfolgen.

Weiterhin kann im Schritt 1) eine automatische Positionierung der elektronischen Einheit 20 durch mindestens ein Positionierungselement 13 am Gehäuse 12, insbesondere in Form einer Positionierungsschiene, durchgeführt werden.

Des Weiteren kann im Schritt 1) eine automatische Positionierung und/oder eine automatische Abdichtung der elektronischen Einheit 20 durch eine Befestigungseinheit 15 für ein Steckergehäuse 32 der elektrischen Steckereinheit 30, insbesondere in Form einer Labyrinthführung, erfolgen. Hierzu kann ein erstes Abdichtelement W1 an einer unteren Wandung der Befestigungseinheit 15 und ggf. eine zusätzliche Dichtung innerhalb der Befestigungseinheit 15 vorgesehen sein.

Im Schritt 3) kann wiederum eine zusätzliche Abdichtung der elektronischen Einheit 20 durch ein Steckergehäuse 32 der elektrischen Steckereinheit 30, insbesondere durch ein zweites elastisches Abdichtelement W2 an mindestens einem Sicherungselement 32a des Steckergehäuses 32, erfolgen.

Zudem kann die Erfindung bei einem Verfahren zur Herstellung einer Griffanordnung vorsehen, dass das Verfahren mindestens einen weiteren Schritt aufweist:
4) Verschrauben, bspw. mithilfe einer Schraube 53, der Lagerkupplung 40 an einer Lageraufnahme 14 des Türgriffes 10.

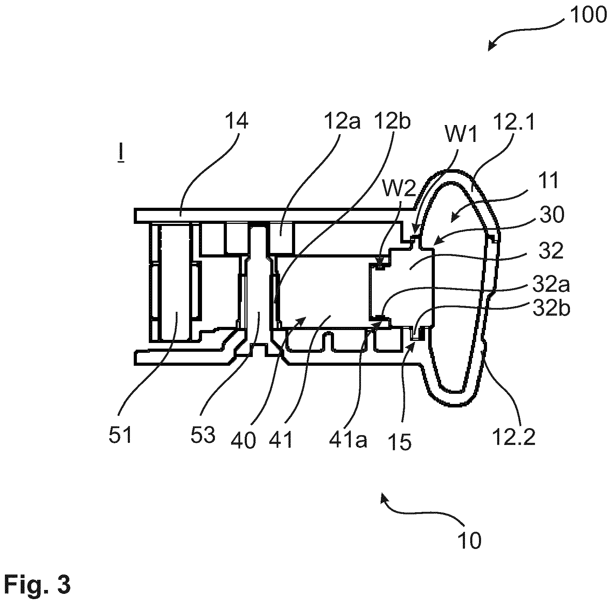

Zur Aufnahme der Schraube 53 können ein Gegenschraubmittel 12a (zum Festziehen der Schraube 53 gegen das Gehäuse 12) am Gehäuse 12, insbesondere an der zweiten Schale 12.2 des Gehäuses 12 des Türgriffes 10 und eine Schraubenführung 12b (nach Art eines Dübels) in der Lagerkupplung 40 vorgesehen sein (siehe die Figuren 3 und 6).

Wie es weiterhin in den Figuren 2 und 6 angedeutet ist, kann eine Lagerachse 51 an einem Montagearm 50 für die Lagerkupplung 40 vorgesehen sein, die zur, bspw. drehbaren, Befestigung der Lagerkupplung 40 am Montageträger 101 des Fahrzeuges 1 dienen kann.

Der Montagearm 50 kann weiterhin ein Funktionselement 52 aufweisen, welches bspw. zu einem nicht dargestellten Schloss führen kann.

Die Figur 7 zeigt schließlich einen entsprechenden Montageträger 101 von hinten, auf welchem weitere Komponenten abgestützt werden können, wie z. B. ein zentraler Stecker 60, ggf. mit einem Kabel 61 zu einer Steuereinheit 70, die Steuereinheit 70, ggf. mit einem Kabel 71 zu einem Motor 80. Der Motor 80 kann dazu dienen, um den Türgriff 10 zwischen einer Ruhestellung in die Betriebsstellung zu überführen.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung, wie in den Ansprüchen definiert, zu verlassen.

### Bezugszeichenliste

- 1: Fahrzeug
- 2: bewegliches Teil
- 3: Fahrzeugelektronik

- 10: Türgriff
- 11: Kavität
- 12: Gehäuse
- 12a: Gegenschraubmittel
- 12b: Schraubenführung
- 12.1: erste Schale
- 12.2: zweite Schale
- 13: Positionierungselement
- 14: Lagerarmaufnahme
- 14a: Montageelement
- 15: Befestigungseinheit

- 20: elektronische Einheit
- 21: Trägereinheit
- 22: Sensoreinheit
- 23: Blende

- 30: elektrische Steckereinheit
- 31: Steckerelement
- 32: Steckergehäuse
- 32a: Sicherungselement
- 32b: Schulter

- 40: Lagerkupplung
- 40a: Gegenmontageelement
- 41: Steckerbuchse
- 41a: Gegensicherungselement

- 50: Montagearm
- 51: Lagerachse
- 52: Funktionselement
- 53: Schraube

- 60: Zentralstecker
- 61: Kabel

- 70: Steuereinheit
- 71: Kabel

- 80: Motor

- 100: Griffanordnung

- 101: Montageträger

- K: elektrische Leitung
- W: Wandung
- W1: Abdichtelement

- I: erste Lagerstelle
- II: zweite Lagerstelle

## Patentansprüche

1. Türgriff (10) für ein Fahrzeug (1), insbesondere ein Türaußengriff (10) für ein bewegliches Teil (2) des Fahrzeuges (1), aufweisend:
- eine Kavität (11), welche zumindest teilweise durch ein Gehäuse (12) des Türgriffs (10) gebildet ist, und
- eine elektronische Einheit (20), welche in der Kavität (11) aufgenommen ist,
wobei die elektronische Einheit (20) eine Trägereinheit (21) aufweist,
- eine elektrische Steckereinheit (30), welche mindestens ein elektrisch leitendes Steckerelement (31) aufweist,
wobei das mindestens eine Steckerelement (31) an der Trägereinheit (21) stoffschlüssig befestigt ist, **dadurch gekennzeichnet, dass**
die elektrische Steckereinheit (30) zum Befestigen einer Lagerkupplung (40), die mit einer elektrischen Leitung (K) ausgeführt ist, an der elektrischen Steckereinheit (30) ausgeführt ist,
wodurch der Türgriff (10) am Fahrzeug, insbesondere an einem Montageträger (101) des Fahrzeuges, mechanisch, insbesondere lösbar, vorzugsweise form- und/oder kraftschlüssig, befestigt wird
und zugleich die elektronische Einheit (20) mit der elektrischen Leitung (K) der Lagerkupplung (40) elektrisch verbunden wird.

2. Türgriff (10) nach Anspruch 1,
**dadurch gekennzeichnet,**
**dass** die elektrische Steckereinheit (30) und/oder die elektronische Einheit (20) kabellos ausgeführt sind/ist,
und/oder dass die Trägereinheit (21) als eine elektrische Platine, insbesondere in Form einer Leiterplatte oder einer gedruckten Schaltung, ausgebildet ist,
und/oder dass die Trägereinheit (21) mindestens eine Leiterbahn und/oder mindestens eine Sensoreinheit (22) aufweist, welche über das mindestens eine Steckerelement (31) mit einer Steckerbuchse (41) elektrisch verbindbar sind/ist,
und/oder dass die elektronische Einheit (20) mindestens eine Leuchteinheit aufweist, welche über das mindestens eine Steckerelement (31) mit einer Steckerbuchse (41) elektrisch verbindbar ist.

3. Türgriff (10) nach einem der vorhergehenden Ansprüche,
**dadurch gekennzeichnet,**
**dass** der Türgriff (10) als ein flächenbündiger Türgriff (10) ausgeführt ist, und vorzugsweise von einer Ruhestellung,
wobei in der Ruhestellung eine Außenfläche des Türgriffes (10) im Wesentlichen bündig zu einer Außenseite des beweglichen Teils (2) ist,
in eine Betriebsstellung bewegbar ist, insbesondere durch eine parallele Bewegung der Außenfläche des beweglichen Teils (2) zur Außenseite des beweglichen Teils (2),
wobei in der Betriebsstellung der Türgriff (10) manuell, bspw. durch Ziehen am Türgriff (10) und/oder Drücken des Türgriffs (10), betätigbar ist,
und/oder dass die elektrische Steckereinheit (30) ein Steckergehäuse (32) aufweist,
wobei insbesondere in dem Steckergehäuse (32) eine Aufnahme für das mindestens eine Steckerelement (31) ausgebildet ist,
sodass das mindestens eine Steckerelement (31) durch mechanisches Verbinden des Steckergehäuses (32) mit einer Steckerbuchse (41) einer Lagerkupplung (40) mit einer elektrischen Leitung (K), insbesondere einem Kabel, der Lagerkupplung (40) elektrisch kontaktierbar ist.

4. Türgriff (10) nach einem der vorhergehenden Ansprüche,
**dadurch gekennzeichnet,**
**dass** ein Steckergehäuse (32) der elektrischen Steckereinheit (30) mindestens ein Sicherungselement (32a) aufweist, um das Steckergehäuse (32) form- und/oder kraftschlüssig mit einer Steckerbuchse (41) einer Lagerkupplung (40) zu verbinden,
wobei insbesondere das mindestens eine Sicherungselement (32a) in Form einer Rastnase, eines Rasthakens oder eines Hinterschnitts für ein komplementäres Gegensicherungselement (41a) an einer Steckerbuchse (41) einer Lagerkupplung (40) ausgebildet ist,
und/oder dass ein Steckergehäuse (32) der elektrischen Steckereinheit (30), insbesondere an dem mindestens einen Sicherungselement (32a), ein zweites elastisches Abdichtelement (W2) aufweist,
um insbesondere die Kavität (11) zusätzlich zu einem ersten elastischen Abdichtelement (W1) abzudichten,
und/oder dass ein Steckergehäuse (32) der elektrischen Steckereinheit (30) als ein Kunststoff-Bauteil ausgeführt ist, insbesondere als ein Zweikomponenten-Spritzgussteil, vorzugsweise aus einem Faser-Kunststoff-Verbund,
und/oder dass ein Steckergehäuse (32) der elektrischen Steckereinheit (30) das mindestens eine Steckerelement (31) als ein eingespritztes Element aufweist.

5. Türgriff (10) nach einem der vorhergehenden Ansprüche,
**dadurch gekennzeichnet,**
**dass** der Türgriff (10) eine Lagerarmaufnahme (14) für eine Lagerkupplung (40) aufweist, die insbesondere eine vollständig geschlossene Umfangskontur für die Lagerkupplung (40) aufweist, die vorzugsweise an den Außenumfang der Lagerkupplung angepasst ist, und die bevorzugt O-förmig oder im Wesentlichen rechteckförmig ausgebildet ist,
und/oder dass die Lagerarmaufnahme (14) ein Montageelement (14a), insbesondere in Form einer Führungsschiene oder eines Führungsrastelementes, für ein komplementäres Gegenmontageelement (40a) der Lagerkupplung (40) aufweist, um die Lagerkupplung (40) in einer definierten Ausrichtung in der Lagerarmaufnahme (14) aufzunehmen,
und/oder dass die Lagerarmaufnahme (14) derart beabstandet zur Außenkontur der elektrischen Steckereinheit (30) ausgeführt ist, dass die elektrische Steckereinheit (30) durch die Lagerarmaufnahme (14) hülsenförmig umschlossen ist, und dass die Lagerarmaufnahme (14) mit der Steckereinheit (30) einen männlichen Steckerteil bilden, in welchem eine Steckerbuchse (41) einer Lagerkupplung (40) lösbar, insbesondere form- und/oder kraftschlüssig, aufnehmbar und elektrisch kontaktierbar ist,
und/oder dass der Türgriff (10) im Bereich zwischen dem Gehäuse (12) und einer Lagerarmaufnahme (14) für eine Lagerkupplung (40) eine Befestigungseinheit (15) für ein Steckergehäuse (32) der elektrischen Steckereinheit (30) aufweist.

6. Türgriff (10) nach dem vorhergehenden Anspruch,
**dadurch gekennzeichnet,**
**dass** die Befestigungseinheit (15) eine Labyrinthführung aufweist, die vorzugsweise mit einer komplementären umfangseitigen Schulter (32b) der elektrischen Steckereinheit (30) zusammenwirkt,
und/oder dass die Befestigungseinheit (15) eine zusätzliche Dichtung, insbesondere innerhalb der Labyrinthführung, zur Abdichtung der Kavität (11) aufweist,
und/oder dass die Befestigungseinheit (15) sich vorzugsweise entlang eines äußeren Umfangs des Steckergehäuses (32) der elektrischen Steckereinheit (30) erstreckt.

7. Türgriff (10) nach einem der vorhergehenden Ansprüche,
**dadurch gekennzeichnet,**
**dass** das Gehäuse (12) des Türgriffs (10) eine erste Schale (12.1) und eine zweite Schale (12.2) aufweist,
und/oder dass das Gehäuse (12) mindestens ein Positionierungselement (13), insbesondere in Form einer Positionierungsschiene, für die Trägereinheit (21) aufweist, um die Trägereinheit (21) in der Kavität zu fixieren,
und/oder dass das Gehäuse (12), insbesondere umfassend eine Lagerarmaufnahme (14) für eine Lagerkupplung (40) und/oder eine Befestigungseinheit (15) für ein Steckergehäuse (32) der elektrischen Steckereinheit (30), zur Abdichtung der Kavität (11) ausgeführt ist,
um insbesondere ein Ausdringen einer Vergussmasse aus der Kavität (11) zu verhindern,
und/oder dass in der Kavität (11) eine Vergussmasse eingespritzt ist, um insbesondere die elektronische Einheit (20) abzudichten,
wobei vorzugsweise die Vergussmasse die elektronische Einheit (20) überwiegend oder vollständig umgibt,
und/oder dass das Gehäuse (12) des Türgriffs (10), insbesondere eine erste Schale (12.1) und eine zweite Schale (12.2), eine Öffnung zum Einspritzen einer Vergussmasse in die Kavität (11) aufweist.

8. Türgriff (10) nach einem der vorhergehenden Ansprüche,
**dadurch gekennzeichnet,**
**dass** das Gehäuse (12), insbesondere eine Lagerarmaufnahme (14) für eine Lagerkupplung (40) und/oder eine Befestigungseinheit (15) für ein Steckergehäuse (32) der elektrischen Steckereinheit (30), eine Wandung (W), insbesondere mit einem ersten elastischen Abdichtelement (W1), aufweist,
wobei vorzugsweise die Wandung (W) die Kavität (11) von einer Lagerarmaufnahme (14) für eine Lagerkupplung (40) abgrenzt,
wobei bevorzugt sich das mindestens eine Steckerelement (31) durch die Wandung (W) hindurch von der Kavität (11) zu einer Lagerarmaufnahme (14) für eine Lagerkupplung (40) erstreckt.

9. Türgriff (10) nach einem der vorhergehenden Ansprüche,
**dadurch gekennzeichnet,**
**dass** eine Blende (23) für die elektronische Einheit (20) vorgesehen ist, welche insbesondere an einer Außenseite des Türgriffes (10), bspw. einer dem beweglichen Teil (2) abgewandten Seite, angeordnet ist, um mindestens eine Sensoreinheit (22) der elektronischen Einheit (20) abzuschirmen und/oder einen Detektionsbereich der mindestens einen Sensoreinheit (22) zu formen,
wobei insbesondere die Blende (23) elektrisch leitfähig und/oder metallisch und/oder als eine Beschichtung, bspw. eine Chrombeschichtung, an der Außenseite des Türgriffs (10) ausgebildet ist,
wobei vorzugsweise die Blende (23) mit der elektrischen Einheit (20) elektrisch verbindbar ist.

10. Griffanordnung (100) für ein Fahrzeug (1), aufweisend:
einen Türgriff (10) nach einem der vorhergehenden Ansprüche und
eine Lagerkupplung (40) zum Befestigen des Türgriffes (10) am Fahrzeug (1), insbesondre an einem Montageträger (101) des Fahrzeuges (1),
wobei die Lagerkupplung (40) mit einer elektrischen Leitung (K) ausgeführt ist,
und wobei die Lagerkupplung (40) mit einer elektrischen Steckereinheit (30) des Türgriffes (10) mechanisch befestigt und elektrisch verbunden ist.

11. Griffanordnung (100) nach dem vorhergehenden Anspruch,
**dadurch gekennzeichnet,**
**dass** der Türgriff (10) eine Lagerarmaufnahme (14) für die Lagerkupplung (40) aufweist, die insbesondere eine vollständig geschlossene Umfangskontur für die Lagerkupplung (40) aufweist, die vorzugsweise an den Außenumfang der Lagerkupplung angepasst ist, und die bevorzugt O-förmig oder im Wesentlichen rechteckförmig ausgebildet ist,
und/oder dass die Lagerarmaufnahme (14) ein Montageelement (14a), insbesondere in Form einer Führungsschiene oder eines Führungsrastelementes aufweist, die oder das mit einem komplementären Kupplungselement (40a) der Lagerkupplung (40) zusammenwirkt, um die Lagerkupplung (40) in einer definierten Ausrichtung in der Lagerarmaufnahme (14) aufzunehmen,
und/oder dass die Lagerarmaufnahme (14) derart beabstandet zur Außenkontur der elektrischen Steckereinheit (30) ausgeführt ist, dass die elektrische Steckereinheit (30) durch die Lagerarmaufnahme (14) hülsenförmig umschlossen ist, und dass die Lagerarmaufnahme (14) mit der Steckereinheit (30) einen männlichen Steckerteil bilden, in welchem eine Steckerbuchse (41) der Lagerkupplung (40) lösbar, insbesondere form-und/oder kraftschlüssig, aufgenommen und elektrisch kontaktiert ist.

12. Griffanordnung (100) nach einem der vorhergehenden Ansprüche 10 oder 11,
**dadurch gekennzeichnet,**
**dass** ein Steckergehäuse (32) der elektrischen Steckereinheit (30) mindestens ein Sicherungselement (32a) aufweist, um das Steckergehäuse (32) form- und/oder kraftschlüssig mit einer Steckerbuchse (41) der Lagerkupplung (40) zu verbinden,
wobei insbesondere das mindestens eine Sicherungselement (32a) in Form einer Rastnase, eines Rasthakens oder eines Hinterschnitts ausgebildet ist, welche oder welcher mit einem komplementären Gegensicherungselement (41a) an einer Steckerbuchse (41) der Lagerkupplung (40) zusammenwirkt.

13. Verfahren zur Herstellung einer Griffanordnung (100) für ein Fahrzeug nach einem der vorhergehenden Ansprüche 10 bis 12,
aufweisend folgende Schritte:
1) Einbringen einer elektronischen Einheit (20) in eine Kavität (11) eines Türgriffs (10), wobei die elektronische Einheit (20) eine Trägereinheit (21) und eine elektrische Steckereinheit (30) aufweist,
2) Einbringen einer Vergussmasse in die Kavität (11), sodass die Vergussmasse die elektronische Einheit (20) zumindest teilweise umgibt,
3) Befestigen einer Lagerkupplung (40), die mit einer elektrischen Leitung (K), insbesondere einem Kabel, ausgeführt ist, an der elektrischen Steckereinheit (30), wodurch der Türgriff (10) am Fahrzeug, insbesondere an einem Montageträger (101) des Fahrzeuges, mechanisch, insbesondere lösbar, vorzugsweise form- und/oder kraftschlüssig, befestigt wird
und zugleich die elektronische Einheit (20) mit der elektrischen Leitung (K) der Lagerkupplung (40) elektrisch verbunden wird.

14. Verfahren nach dem vorhergehenden Anspruch,
**dadurch gekennzeichnet,**
**dass** im Schritt 1) das Einbringen der elektronischen Einheit (20) in die Kavität (11) zumindest teilweise automatisch oder vollautomatisch, vorzugsweise über einen Roboter, erfolgt,
und/oder dass im Schritt 1) eine automatische Positionierung der elektronischen Einheit (20) durch mindestens ein Positionierungselement (13) am Gehäuse (12), insbesondere in Form einer Positionierungsschiene, durchgeführt wird,
und/oder dass im Schritt 1) eine automatische Positionierung und/oder eine automatische Abdichtung der elektronischen Einheit (20) durch eine Befestigungseinheit (15) für ein Steckergehäuse (32) der elektrischen Steckereinheit (30), insbesondere in Form einer Labyrinthführung, durchgeführt wird,
und/oder dass im Schritt 3) eine zusätzliche Abdichtung der elektronischen Einheit (20) durch ein Steckergehäuse (32) der elektrischen Steckereinheit (30), insbesondere durch ein zweites elastisches Abdichtelement (W2) an mindestens einem Sicherungselement (32a) des Steckergehäuses (32), durchgeführt wird,
und/oder dass das Verfahren mindestens einen weiteren Schritt aufweist: 4) Verschrauben der Lagerkupplung (40) an einer Lageraufnahme (14) des Türgriffes (10).

## Claims

1. A door handle (10) for a vehicle (1), in particular a door outer handle (10) for a movable part (2) of the vehicle (1), comprising:
- a cavity (11), which is at least partially formed by a housing (12) of the door handle (10), and
- an electronic unit (20), which is received in the cavity (11),
wherein the electronic unit (20) comprises a support unit (21),
- an electrical plug unit (30), which comprises at least one electrically conducting plug element (31),
wherein the at least one plug element (31) is attached to the support unit (21) in firmly bonded manner, **characterized in that**
the electrical plug unit (30) is configured for attaching a bearing coupling (40), which is configured with an electrical line (K), to the electrical plug unit (30), whereby the door handle (10) is attached to the vehicle, in particular to a mounting support (101) of the vehicle, in mechanical, in particular detachable, preferably form- and/or force-fit manner,
and the electronic unit (20) is electrically connected to the electrical line (K) of the bearing coupling (40) at the same time.

2. The door handle (10) according to claim 1,
**characterized in that**
the electrical plug unit (30) and/or the electronic unit (20) is/are cordlessly configured,
and/or that the support unit (21) is formed as an electrical board, in particular in the form of a circuit board or a printed circuit,
and/or that the support unit (21) comprises at least one conductor path and/or at least one sensor unit (22), which is/are electrically connectable to a plug socket (41) via the at least one plug element (31),
and/or that the electronic unit (20) comprises at least one lighting unit, which is electrically connectable to a plug socket (41) via the at least one plug element (31).

3. The door handle (10) according to any one of the preceding claims, **characterized in that**
the door handle (10) is configured as a door handle (10) flush in surface, and is preferably movable from a rest position,
wherein an outer surface of the door handle (10) is substantially flush with an outer side of the movable part (2) in the rest position,
into an operating position, in particular by a parallel movement of the outer surface of the movable part (2) to the outer side of the movable part (2), wherein the door handle (10) can be manually actuated, for example by pulling on the door handle (10) and/or pressing the door handle (10), in the operating position,
and/or that the electrical plug unit (30) comprises a plug housing (32), wherein a receptacle for the at least one plug element (31) is in particular formed in the plug housing (32),
such that, by mechanically connecting the plug housing (32) to a plug socket (41) of a bearing coupling (40), the at least one plug element (31) can be electrically contacted with an electrical line (K), in particular a cable, of the bearing coupling (40).

4. The door handle (10) according to any one of the preceding claims, **characterized in that**
a plug housing (32) of the electrical plug unit (30) comprises at least one securing element (32a) to connect the plug housing (32) to a plug socket (41) of a bearing coupling (40) in form- and/or force-fit manner,
wherein the at least one securing element (32a) is in particular formed in the form of a locking lug, a locking hook or an undercut for a complementary mating securing element (41a) on a plug socket (41) of a bearing coupling (40),
and/or that a plug housing (32) of the electrical plug unit (30) comprises a second elastic sealing element (W2), in particular on the at least one securing element (32a),
to in particular seal the cavity (11) in addition to a first elastic sealing element (W1),
and/or that a plug housing (32) of the electrical plug unit (30) is configured as a plastic member, in particular as a two-component injection-molded part, preferably of a fiber-plastic compound,
and/or that a plug housing (32) of the electrical plug unit (30) comprises the at least one plug element (31) as an injected element.

5. The door handle (10) according to any one of the preceding claims, **characterized in that**
the door handle (10) comprises a bearing arm receptacle (14) for a bearing coupling (40), which in particular comprises a completely closed circumferential contour for the bearing coupling (40), which is preferably adapted to the outer circumference of the bearing coupling, and which is preferably O-shaped or substantially rectangularly formed,
and/or that the bearing arm receptacle (14) comprises a mounting element (14a), in particular in the form of a guide rail or a guide locking element, for a complementary mating mounting element (40a) of the bearing coupling (40), to receive the bearing coupling (40) in the bearing arm receptacle (14) in a defined orientation,
and/or that the bearing arm receptacle (14) is configured spaced from the outer contour of the electrical plug unit (30) such that the electrical plug unit (30) is sleeve-shaped enclosed by the bearing arm receptacle (14), and that the bearing arm receptacle (14) forms a male plug part with the plug unit (30), in which a plug socket (41) of a bearing coupling (40) can be received and electrically contacted in detachable, in particular form- and/or force-fit manner,
and/or that the door handle (10) comprises an attaching unit (15) for a plug housing (32) of the electrical plug unit (30) in the area between the housing (12) and a bearing arm receptacle (14) for a bearing coupling (40).

6. The door handle (10) according to the preceding claim,
**characterized in that**
the attaching unit (15) comprises a labyrinth guide, which preferably cooperates with a complementary circumferential shoulder (32b) of the electrical plug unit (30),
and/or that the attaching unit (15) comprises an additional seal, in particular within the labyrinth guide, for sealing the cavity (11),
and/or that the attaching unit (15) preferably extends along an outer circumference of the plug housing (32) of the electrical plug unit (30).

7. The door handle (10) according to any one of the preceding claims, **characterized in that**
the housing (12) of the door handle (10) comprises a first shell (12.1) and a second shell (12.2),
and/or that the housing (12) comprises at least one positioning element (13), in particular in the form of a positioning rail, for the support unit (21), to fix the support unit (21) in the cavity,
and/or that the housing (12), in particular including a bearing arm receptacle (14) for a bearing coupling (40) and/or an attaching unit (15) for a plug housing (32) of the electrical plug unit (30), is configured for sealing the cavity (11),
to in particular prevent egress of a casting compound from the cavity (11), and/or that a casting compound is injected in the cavity (11) to in particular seal the electronic unit (20),
wherein the casting compound preferably predominantly or completely surrounds the electronic unit (20),
and/or that the housing (12) of the door handle (10), in particular a first shell (12.1) and a second shell (12.2), comprises an opening for injecting a casting compound into the cavity (11).

8. The door handle (10) according to any one of the preceding claims, **characterized in that**
the housing (12), in particular a bearing arm receptacle (14) for a bearing coupling (40) and/or an attaching unit (15) for a plug housing (32) of the electrical plug unit (30), comprises a wall (W), in particular with a first elastic sealing element (W1),
wherein the wall (W) preferably delimits the cavity (11) from a bearing arm receptacle (14) for a bearing coupling (40),
wherein the at least one plug element (31) preferably extends through the wall (W) from the cavity (11) to a bearing arm receptacle (14) for a bearing coupling (40).

9. The door handle (10) according to any one of the preceding claims, **characterized in that**
a shield (23) is provided for the electronic unit (20), which is in particular arranged on an outer side of the door handle (10), for example on a side facing away from the movable part (2), to shield at least one sensor unit (22) of the electronic unit (20) and/or to form a detection area of the at least one sensor unit (22),
wherein the shield (23) is in particular formed electrically conductive and/or metallic and/or as a coating, for example a chrome coating, on the outer side of the door handle (10),
wherein the shield (23) is preferably electrically connectable to the electrical unit (20).

10. A handle assembly (100) for a vehicle (1), comprising:
a door handle (10) according to any one of the preceding claims, and
a bearing coupling (40) for attaching the door handle (10) to the vehicle (1),
in particular to a mounting support (101) of the vehicle (1),
wherein the bearing coupling (40) is configured with an electrical line (K),
and wherein the bearing coupling (40) is mechanically attached and
electrically connected to an electrical plug unit (30) of the door handle (10).

11. The handle assembly (100) according to the preceding claim, **characterized in that**
the door handle (10) comprises a bearing arm receptacle (14) for the bearing coupling (40), which in particular comprises a completely closed circumferential contour for the bearing coupling (40), which is preferably adapted to the outer circumference of the bearing coupling, and which is preferably O-shaped or substantially rectangularly formed,
and/or that the bearing arm receptacle (14) comprises a mounting element (14a), in particular in the form of a guide rail or a guide locking element, which cooperates with a complementary coupling element (40a) of the bearing coupling (40), to receive the bearing coupling (40) in the bearing arm receptacle (14) in a defined orientation,
and/or that the bearing arm receptacle (14) is configured spaced from the outer contour of the electrical plug unit (30) such that the electrical plug unit (30) is sleeve-shaped enclosed by the bearing arm receptacle (14), and that the bearing arm receptacle (14) forms a male plug part with the plug unit (30), in which a plug socket (41) of the bearing coupling (40) is received and electrically contacted in detachable, in particular form- and/or force-fit manner.

12. The handle assembly (100) according to any one of the preceding claims 10 or 11,
**characterized in that**
a plug housing (32) of the electrical plug unit (30) comprises at least one securing element (32a), to connect the plug housing (32) to a plug socket (41) of the bearing coupling (40) in form- and/or force-fit manner,
wherein the at least one securing element (32a) is in particular formed in the form of a locking lug, a locking hook or an undercut, which cooperates with a complementary mating securing element (41a) on a plug socket (41) of the bearing coupling (40).

13. A method for producing a handle assembly (100) for a vehicle according to any one of the preceding claims 10 to 12,
comprising the following steps:
1) introducing an electronic unit (20) into a cavity (11) of a door handle (10), wherein the electronic unit (20) comprises a support unit (21) and an electrical plug unit (30),
2) introducing a casting compound into the cavity (11) such that the casting compound at least partially surrounds the electronic unit (20),
3) attaching a bearing coupling (40), which is configured with an electrical line (K), in particular a cable, to the electrical plug unit (30), whereby the door handle (10) is attached to the vehicle, in particular to a mounting support (101) of the vehicle, in mechanical, in particular detachable, preferably form-and/or force-fit manner,
and the electronic unit (20) is electrically connected to the electrical line (K) of the bearing coupling (40) at the same time.

14. The method according to the preceding claim,
**characterized in that**
in step 1), the introduction of the electronic unit (20) into the cavity (11) is at least partially automatically or fully automatically effected, preferably via a robot,
and/or that in step 1), automatic positioning of the electronic unit (20) is performed by at least one positioning element (13) on the housing (12), in particular in the form of a positioning rail,
and/or that in step 1), automatic positioning and/or automatic sealing of the electronic unit (20) is performed by an attaching unit (15) for a plug housing (32) of the electrical plug unit (30), in particular in the form of a labyrinth guide,
and/or that in step 3), additional sealing of the electronic unit (20) is performed by a plug housing (32) of the electrical plug unit (30), in particular by a second elastic sealing element (W2) on at least one securing element (32a) of the plug housing (32),
and/or that the method comprises at least one further step:
4) screwing the bearing coupling (40) to a bearing receptacle (14) of the door handle (10).

## Revendications

1. Poignée de porte (10) pour un véhicule (1), en particulier poignée extérieure de porte (10) pour une partie (2) mobile du véhicule (1), présentant :
- une cavité (11), laquelle est formée au moins partiellement par un boîtier (12) de la poignée de porte (10), et
- une unité (20) électronique, laquelle est logée dans la cavité (11), l'unité (20) électronique présentant une unité de support (21),
- une unité de connecteur (30) électrique, laquelle présente au moins un élément connecteur (31) électroconducteur,
l'au moins un élément connecteur (31) étant fixé par liaison de matière à l'unité de support (21), **caractérisée en ce que**
l'unité de connecteur (30) électrique est réalisée pour la fixation d'un accouplement d'appui (40), qui est réalisé avec une ligne (K) électrique, à l'unité de connecteur (30) électrique,
de sorte que la poignée de porte (10) soit fixée au véhicule, en particulier à un support de montage (101) du véhicule, de manière mécanique, en particulier amovible, de préférence par engagement par complémentarité de formes et/ou par force,
et en même temps l'unité (20) électronique est connectée électriquement à la ligne (K) électrique de l'accouplement d'appui (40).

2. Poignée de porte (10) selon la revendication 1, **caractérisée en ce que**
l'unité de connecteur (30) électrique et/ou l'unité (20) électronique est/sont réalisée(s) sans câble,
et/ou **en ce que** l'unité de support (21) est formée comme une plaquette électrique, en particulier sous la forme d'une carte de circuits imprimés ou d'un circuit imprimé, et/ou **en ce que** l'unité de support (21) présente au moins une piste conductrice et/ou au moins une unité de détection (22), laquelle/lesquelles peu(ven)t être reliée(s) électriquement à un connecteur femelle (41) par le biais de l'au moins un élément connecteur (31),
et/ou **en ce que** l'unité (20) électronique présente au moins une unité d'éclairage, laquelle peut être connectée électriquement à un connecteur femelle (41) par le biais de l'au moins un élément connecteur (31).

3. Poignée de porte (10) selon l'une des revendications précédentes,
**caractérisée en ce que**
la poignée de porte (10) est réalisée sous la forme d'une poignée de porte (10) en affleurement de surface, et peut être déplacée de préférence d'une position de repos,
une surface extérieure de la poignée de porte (10) étant sensiblement en affleurement par rapport à un côté extérieur de la partie (2) mobile dans la position de repos,
à une position de fonctionnement, en particulier par un mouvement parallèle de la surface extérieure de la partie (2) mobile par rapport au côté extérieur de la partie (2) mobile,
la poignée de porte (10) pouvant être actionnée manuellement, par exemple par traction sur la poignée de porte (10) et/ou pression de la poignée de porte (10), dans la position de fonctionnement,
et/ou **en ce que** l'unité de connecteur (30) électrique présente un boîtier de connecteur (32),
un logement pour l'au moins un élément connecteur (31) étant formé en particulier dans le boîtier de connecteur (32),
de sorte que l'au moins un élément connecteur (31), par connexion mécanique du boîtier de connecteur (32) à un connecteur femelle (41) d'un accouplement d'appui (40), peut être mis en contact électrique avec une ligne (K) électrique, en particulier un câble, de l'accouplement d'appui (40).

4. Poignée de porte (10) selon l'une des revendications précédentes,
**caractérisée en ce**
**qu'**un boîtier de connecteur (32) de l'unité de connecteur (30) électrique présente au moins un élément d'assujettissement (32a), pour connecter le boîtier de connecteur (32) par engagement par complémentarité de formes et/ou par force à un connecteur femelle (41) d'un accouplement d'appui (40),
en particulier l'au moins un élément d'assujettissement (32a) étant formé sous la forme d'un ergot d'encliquetage, d'un crochet d'encliquetage ou d'une contre-dépouille pour un élément d'assujettissement conjugué (41a) complémentaire sur un connecteur femelle (41) d'un accouplement d'appui (40),
et/ou en ce qu'un boîtier de connecteur (32) de l'unité de connecteur (30) électrique présente, en particulier au niveau de l'au moins un élément d'assujettissement (32a), un deuxième élément d'étanchéité (W2) élastique, afin de rendre étanche en particulier la cavité (11) en outre par rapport à un premier élément d'étanchéité (W1) élastique,
et/ou en ce qu'un boîtier de connecteur (32) de l'unité de connecteur (30) électrique est réalisé sous la forme d'un composant en matière synthétique, en particulier sous la forme d'une pièce moulée par injection à deux composants, de préférence à partir d'une matière synthétique composite renforcée par des fibres,
et/ou en ce qu'un boîtier de connecteur (32) de l'unité de connecteur (30) électrique présente l'au moins un élément connecteur (31) sous la forme d'un élément injecté.

5. Poignée de porte (10) selon l'une des revendications précédentes,
**caractérisée en ce que**
la poignée de porte (10) présente un logement de bras d'appui (14) pour un accouplement d'appui (40), lequel logement présente en particulier un contour périphérique complètement fermé pour l'accouplement d'appui (40), lequel contour est adapté de préférence à la périphérie extérieure de l'accouplement d'appui, et lequel est formé de préférence en forme de O ou sensiblement sous forme rectangulaire,
et/ou **en ce que** le logement de bras d'appui (14) présente un élément de montage (14a), en particulier sous la forme d'un rail de guidage ou d'un élément d'encliquetage de guidage, pour un élément de montage conjugué (40a) complémentaire de l'accouplement d'appui (40), afin de loger l'accouplement d'appui (40) dans une orientation définie dans le logement de bras d'appui (14),
et/ou **en ce que** le logement de bras d'appui (14) est réalisé de manière espacée du contour extérieur de l'unité de connecteur (30) électrique, de telle sorte que l'unité de connecteur (30) électrique soit entourée en forme de douille par le logement de bras d'appui (14), et que le logement de bras d'appui (14) forme avec l'unité de connecteur (30) une partie de connecteur mâle, dans laquelle un connecteur femelle (41) d'un accouplement d'appui (40) peut être logé de manière amovible, en particulier par engagement par complémentarité de formes et/ou par force, et peut être mis en contact électrique, et/ou **en ce que** la poignée de porte (10) présente, dans la région entre le boîtier (12) et un logement de bras d'appui (14) pour un accouplement d'appui (40), une unité de fixation (15) pour un boîtier de connecteur (32) de l'unité de connecteur (30) électrique.

6. Poignée de porte (10) selon la revendication précédente,
**caractérisée en ce que**
l'unité de fixation (15) présente un guide à labyrinthe, qui coopère de préférence avec un épaulement (32b) complémentaire côté périphérique de l'unité de connecteur (30) électrique,
et/ou **en ce que** l'unité de fixation (15) présente un joint d'étanchéité supplémentaire, en particulier à l'intérieur du guide à labyrinthe, pour réaliser l'étanchéité de la cavité (11),
et/ou **en ce que** l'unité de fixation (15) s'étend de préférence le long d'une périphérie extérieure du boîtier de connecteur (32) de l'unité de connecteur (30) électrique.

7. Poignée de porte (10) selon l'une des revendications précédentes,
**caractérisée en ce que**
le boîtier (12) de la poignée de porte (10) présente une première enveloppe (12.1) et une deuxième enveloppe (12.2),
et/ou **en ce que** le boîtier (12) présente au moins un élément de positionnement (13), en particulier sous la forme d'un rail de positionnement, pour l'unité de support (21), afin de fixer l'unité de support (21) dans la cavité,
et/ou **en ce que** le boîtier (12) est réalisé en particulier de manière à ceindre un logement de bras d'appui (14) pour un accouplement d'appui (40) et/ou une unité de fixation (15) pour un boîtier de connecteur (32) de l'unité de connecteur (30) électrique, pour réaliser l'étanchéité de la cavité (11),
afin d'empêcher en particulier une fuite d'une masse de scellement hors de la cavité (11),
et/ou **en ce qu'**une masse de scellement est injectée dans la cavité (11), afin de rendre étanche en particulier l'unité (20) électronique,
de préférence la masse de scellement entourant essentiellement ou complètement l'unité (20) électronique,
et/ou **en ce que** le boîtier (12) de la poignée de porte (10), en particulier une première enveloppe (12.1) et une deuxième enveloppe (12.2), présentent une ouverture pour l'injection d'une masse de scellement dans la cavité (11) .

8. Poignée de porte (10) selon l'une des revendications précédentes,
**caractérisée en ce que**
le boîtier (12), en particulier un logement de bras d'appui (14) pour un accouplement d'appui (40) et/ou une unité de fixation (15) pour un boîtier de connecteur (32) de l'unité de connecteur (30) électrique, présentent une paroi (W), en particulier dotée d'un premier élément d'étanchéité (W1) élastique,
de préférence la paroi (W) délimitant la cavité (11) par rapport à un logement de bras d'appui (14) pour un accouplement d'appui (40),
de préférence l'au moins un élément connecteur (31) s'étendant à travers la paroi (W) à partir de la cavité (11) jusqu'à un logement de bras d'appui (14) pour un accouplement d'appui (40).

9. Poignée de porte (10) selon l'une des revendications précédentes,
**caractérisée en ce**
**qu'**un écran (23) pour l'unité (20) électronique est prévu, lequel est disposé en particulier sur un côté extérieur de la poignée de porte (10), par exemple sur un côté opposé à la partie (2) mobile, afin de protéger au moins une unité de détection (22) de l'unité (20) électronique et/ou de former une région de détection de l'au moins une unité de détection (22),
en particulier l'écran (23) étant formé de manière électroconductrice et/ou métallique et/ou sous la forme d'un revêtement, par exemple d'un revêtement en chrome, sur le côté extérieur de la poignée de porte (10),
de préférence l'écran (23) pouvant être connecté électriquement à l'unité (20) électrique.

10. Ensemble de poignée (100) pour un véhicule (1), présentant :
une poignée de porte (10) selon l'une des revendications précédentes et
un accouplement d'appui (40) pour la fixation de la poignée de porte (10) au véhicule (1), en particulier à un support de montage (101) du véhicule (1),
l'accouplement d'appui (40) étant réalisé avec une ligne (K) électrique,
et l'accouplement d'appui (40) étant fixé mécaniquement et connecté électriquement à une unité de connecteur (30) électrique de la poignée de porte (10).

11. Ensemble de poignée (100) selon la revendication précédente,
**caractérisé en ce que**
la poignée de porte (10) présente un logement de bras d'appui (14) pour l'accouplement d'appui (40), lequel logement présente en particulier un contour périphérique complètement fermé pour l'accouplement d'appui (40), lequel contour est adapté de préférence à la périphérie extérieure de l'accouplement d'appui, et lequel est formé de préférence en forme de O ou sensiblement sous forme rectangulaire,
et/ou **en ce que** le logement de bras d'appui (14) présente un élément de montage (14a), en particulier sous la forme d'un rail de guidage ou d'un élément d'encliquetage de guidage, qui coopère avec un élément d'accouplement (40a) complémentaire de l'accouplement d'appui (40), afin de loger l'accouplement d'appui (40) dans une orientation définie dans le logement de bras d'appui (14),
et/ou **en ce que** le logement de bras d'appui (14) est réalisé de manière espacée du contour extérieur de l'unité de connecteur (30) électrique, de telle sorte que l'unité de connecteur (30) électrique soit entourée en forme de douille par le logement de bras d'appui (14), et que le logement de bras d'appui (14) forme avec l'unité de connecteur (30) une partie de connecteur mâle, dans laquelle un connecteur femelle (41) de l'accouplement d'appui (40) est logé de manière amovible, en particulier par engagement par complémentarité de formes et/ou par force, et est mis en contact électrique.

12. Ensemble de poignée (100) selon l'une des revendications précédentes 10 ou 11,
**caractérisé en ce**
**qu'**un boîtier de connecteur (32) de l'unité de connecteur (30) électrique présente au moins un élément d'assujettissement (32a), pour connecter le boîtier de connecteur (32) par engagement par complémentarité de formes et/ou par force à un connecteur femelle (41) de l'accouplement d'appui (40),
en particulier l'au moins un élément d'assujettissement (32a) étant formé sous la forme d'un ergot d'encliquetage, d'un crochet d'encliquetage ou d'une contre-dépouille, lequel ou laquelle coopère avec un élément d'assujettissement conjugué (41a) complémentaire sur un connecteur femelle (41) de l'accouplement d'appui (40) .

13. Procédé de fabrication d'un ensemble de poignée (100) pour un véhicule selon l'une des revendications précédentes 10 à 12,
présentant les étapes suivantes :
1) introduction d'une unité (20) électronique dans une cavité (11) d'une poignée de porte (10), l'unité (20) électronique présentant une unité de support (21) et une unité de connecteur (30) électrique,
2) introduction d'une masse de scellement dans la cavité (11), de sorte que la masse de scellement entoure au moins partiellement l'unité (20) électronique,
3) fixation d'un accouplement d'appui (40), qui est réalisé avec une ligne (K) électrique, en particulier un câble, à l'unité de connecteur (30) électrique, de sorte que la poignée de porte (10) soit fixée au véhicule, en particulier à un support de montage (101) du véhicule, de manière mécanique, en particulier amovible, de préférence par engagement par complémentarité de formes et/ou par force,
et en même temps l'unité (20) électronique est connectée électriquement à la ligne (K) électrique de l'accouplement d'appui (40).

14. Procédé selon la revendication précédente, **caractérisé en ce**
**qu'**à l'étape 1) l'introduction de l'unité (20) électronique dans la cavité (11) s'effectue au moins partiellement automatiquement ou de manière complètement automatique, de préférence par le biais d'un robot, et/ou en ce qu'à l'étape 1) un positionnement automatique de l'unité (20) électronique est effectué par le biais d'au moins un élément de positionnement (13) sur le boîtier (12), en particulier sous la forme d'un rail de positionnement,
et/ou en ce qu'à l'étape 1) un positionnement automatique et/ou une étanchéité automatique de l'unité (20) électronique est/sont effectués par le biais d'une unité de fixation (15) pour un boîtier de connecteur (32) de l'unité de connecteur (30) électrique, en particulier sous la forme d'un guide à labyrinthe,
et/ou en ce qu'à l'étape 3) une étanchéité supplémentaire de l'unité (20) électronique est effectuée par le biais d'un boîtier de connecteur (32) de l'unité de connecteur (30) électrique, en particulier par le biais d'un deuxième élément d'étanchéité (W2) élastique sur au moins un élément d'assujettissement (32a) du boîtier de connecteur (32),
et/ou en ce que le procédé présente au moins une autre étape :
4) vissage de l'accouplement d'appui (40) sur un logement d'appui (14) de la poignée de porte (10).
